# EUROPEAN PATENT SPECIFICATION

(11) **EP 4 366 487 B1**
(45) Date of publication and mention of the grant of the patent: **26.08.2026**
(21) Application number: 23207296.7
(22) Date of filing: 01.11.2023
(51) Int. Cl.: H10K 59/123, H10K 59/179, H10K 59/80

(54) **DISPLAY PANEL**
ANZEIGETAFEL
PANNEAU D'AFFICHAGE

(30) Priority: 04.11.2022 KR 20220145939
(43) Date of publication of application: 08.05.2024
(73) Proprietor: Samsung Display Co., Ltd., Gyeonggi-Do (KR)
(72) Inventor: KIM, Sunho, Yongin-si (KR); KO, Yoomin, Yongin-si (KR); KIM, Hyewon, Yongin-si (KR); PARK, Juchan, Yongin-si (KR); LEE, Pilsuk, Yongin-si (KR); CHOI, Chung Sock, Yongin-si (KR); HONG, Sungjin, Yongin-si (KR)
(74) Representative: Marks & Clerk LLP

(56) References cited:
- US-A1- 2006 119 260
- US-A1- 2010 231 490
- US-A1- 2013 026 475

## Description

### BACKGROUND

### 1. Technical Field

The disclosure relates to a display panel. More specifically, the disclosure relates to a display panel with improved electrical reliability and high resolution.

### 2. Description of the Related Art

Multimedia electronic devices, such as televisions, mobile phones, tablet computers, computers, navigation devices, and game devices, include a display panel displaying an image.

The display panel includes light emitting devices and a pixel driver to drive the light emitting device. The light emitting devices included in the display panel emit a light in response to electrical characteristics controlled by the pixel driver and generate the image. Researches on connections between the light emitting devices and the pixel driver are being in progress to improve a reliability of the display panel.

US 2006/119260 A1 relates to an organic electroluminescence display and a method for manufacturing such a display.

### SUMMARY

The disclosure provides a display panel with improved electrical reliability.

The disclosure provides a display panel with high resolution.

The technical objectives to be achieved by the disclosure are not limited to those described herein, and other technical objectives that are not mentioned herein would be clearly understood by a person skilled in the art from the description of the disclosure.

Embodiments of the disclosure provide a display panel including a transistor, a light emitting device disposed on the transistor, an insulating layer disposed on the transistor and including a first opening, and a connection wiring at least partially covered by the insulating layer and electrically connecting the light emitting device and the transistor. The connection wiring includes a first connection part electrically connected to the light emitting device and including a second opening, a second connection part electrically connected to the transistor, and a connection part extending from the first connection part to the second connection part. An inner side surface of the connection wiring, which defines the second opening, includes a first portion overlapping the first opening and a second portion covered by the insulating layer.

The first portion may be disposed closer to a center of the first opening than the second portion is when viewed in a plane.

Each of the first portion and the second portion may have a curved line shape when viewed in a plane, a curvature center of the first portion may be defined inside the first connection part, and a curvature center of the second portion may be defined outside the first connection part.

Each of the first portion and the second portion may have a straight line shape defined by straight lines when viewed in a plane, the first portion may have a vertex where the straight lines meet each other, the vertex of the first portion may be relatively closer to a center of the first opening than the second portion is, the second portion may have a vertex where the straight lines meet each other, and the vertex of the second portion may be relatively farther away from the center of the first opening than the first portion is.

The first portion may include a plurality of first portions, the second portion may include a plurality of second portions, and the plurality of first portions may be alternately arranged with the plurality of second portions.

The first opening may have a circular shape when viewed in a plane.

According an aspect of the claimed invention, the connection wiring includes a first layer and a second layer disposed under the first layer, an inner side surface of the first layer protrudes more than an inner side surface of the second layer in the first portion to provide a tip part, and the inner side surface of the first layer is aligned with the inner side surface of the second layer in the second portion.

The light emitting device may include a first electrode, a second electrode disposed on the first electrode, and a light emitting layer disposed between the first and second electrodes, and the second electrode may be electrically connected to the inner side surface of the second layer in the first portion.

The display panel further includes a pixel definition layer disposed on the insulating layer and including a third opening exposing a portion of the first electrode, and a fourth opening overlapping the first opening and a separator disposed on the pixel definition layer.

The display panel may further include a capping pattern covering the connection wiring exposed through the first opening, and the capping pattern may contact the first portion and is spaced apart from the second portion.

Embodiments of the disclosure provide a display panel including a transistor, a light emitting device disposed on the transistor, an insulating layer disposed on the transistor and including a first opening, and a connection wiring at least partially covered by the insulating layer and electrically connecting the light emitting device and the transistor. The connection wiring includes a first connection part including a first portion extending in a direction and a second portion extending from the first portion to a first cross direction intersecting the direction and electrically connected to the light emitting device, a second connection part electrically connected to the transistor, and a connection part extending from the first connection part to the second connection part. At least one of a first side surface of the first portion extending in the direction and a second side surface of the second portion extending in the first cross direction overlaps the first opening.

An angle between the first side surface and the second side surface may be smaller than about 180 degrees.

The connection wiring may further include a third portion extending from the second portion to a second cross direction intersecting the first cross direction and facing the first portion in the first cross direction, and at least a portion of the first side surface, the second side surface, and a third side surface of the third portion extending in the second cross direction overlap the first opening.

The connection wiring further includes a third portion extending from the second portion to a second cross direction intersecting the first cross direction and facing the first portion in the first cross direction, at least a portion of the first side surface and at least a portion of a third side surface of the third portion extending in the second cross direction overlap the first opening, and the second side surface does not overlap the first opening.

The first side surface overlapping the first opening may include concave portions and convex portions alternately arranged with the concave portions, each of the concave portions has a curvature allowing a curvature center to be defined outside the first portion, and each of the convex portions has a curvature allowing a curvature center to be defined inside the first portion.

The first side surface further may include a dummy portion covered by the insulating layer, and the dummy portion may have a shape corresponding to a shape of a portion of the concave portions or the convex portions.

The first side surface overlapping the first opening may include concave portions and convex portions alternately arranged with the concave portions, each of the concave portions and each of the convex portions may be defined by straight lines when viewed in a plane, and a center of each of the concave portions and a center of each of the convex portions may be spaced apart from each other to directions opposite to each other with respect to an imaginary line extending in the direction.

According an aspect of the claimed invention, the connection wiring includes a first layer and a second layer disposed under the first layer, a side surface of the first layer protrudes more than a side surface of the second layer in a portion of the first and second side surfaces, which overlaps the first opening to provide a tip part.

The light emitting device may include a first electrode, a second electrode disposed on the first electrode, and a light emitting layer disposed between the first and second electrodes, and the second electrode may be electrically connected to the side surface of the second layer in the portion of the first and second side surfaces, which overlaps the first opening.

The display panel may further include a pixel definition layer disposed on the insulating layer and including a light emitting opening exposing a portion of the first electrode, and a second opening overlapping the first opening, and a separator disposed on the pixel definition layer.

At least some of the above and other features of the invention are set out in the claims.

According to the above, the connection wiring connecting a pixel driver of a pixel and the light emitting device is provided in a way that allows a connection area between a cathode and the connection wiring to increase and that prevents a voltage drop from occurring. In addition, even in the case that a process error occurs during a process of forming an opening of the insulating layer, a sufficient connection area between the cathode and the connection wiring is secured. Accordingly, the electrical reliability of the display panel is improved. As an opening area of the insulating layer is reduced while securing sufficient connection area between the cathode and the connection wiring, the high resolution of the display panel is readily implemented.

### BRIEF DESCRIPTION OF THE DRAWINGS

The above and other advantages of the disclosure will become readily apparent by reference to the following detailed description when considered in conjunction with the accompanying drawings wherein:
FIG. 1 is a schematic block diagram of a display device according to an embodiment of the disclosure;
FIGS. 2A and 2B are schematic diagrams of equivalent circuits of pixels according to embodiments of the disclosure;
FIGS. 3A and 3B are schematic plan views of display panels according to embodiments of the disclosure;
FIGS. 4A to 4C are schematic enlarged plan views of some areas of a display panel according to an embodiment of the disclosure;
FIG. 5 is a schematic enlarged plan view of area AA' of a display area of FIG. 4B according to an embodiment of the disclosure;
FIG. 6A is a schematic enlarged cross-sectional view of a display panel taken along line I-I' of FIG. 4A according to an embodiment of the disclosure;
FIG. 6B is a schematic enlarged plan view of an area BB' of a display panel of FIG. 6A according to an embodiment of the disclosure;
FIG. 6C is a schematic enlarged plan view of area CC' of a display panel of FIG. 6B according to an embodiment of the disclosure;
FIG. 7 is a schematic enlarged plan view of a portion of a display area according to an embodiment of the disclosure;
FIG. 8 is a schematic enlarged plan view of a portion of a display area according to an embodiment of the disclosure;
FIGS. 9A and 9B are schematic enlarged plan views of a portion of a display area according to an embodiment of the disclosure;
FIG. 10 is a schematic enlarged plan view of a portion of a display area according to an embodiment of the disclosure;
FIG. 11 is a schematic enlarged plan view of a portion of a display area according to an embodiment of the disclosure;
FIG. 12 is a schematic enlarged plan view of a portion of a display area according to an embodiment of the disclosure; and
FIG. 13 is a schematic enlarged plan view of a portion of a display area according to an embodiment of the disclosure.

### DETAILED DESCRIPTION OF THE EMBODIMENTS

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements.

Like reference numerals and/or reference characters refer to like elements throughout. In the drawings, the thickness, ratio, and dimension of components are exaggerated for effective description of the technical content. As used herein, the term "and/or" may include any and all combinations of one or more of the associated listed items.

It will be understood that, although the terms first, second, and the like may be used herein to describe various elements, these elements should not be limited by these terms. These terms are only used to distinguish one element from another element. Thus, a first element discussed below could be termed a second element without departing from the teachings of the disclosure. As used herein, the singular forms, such as "a" and "an"," are intended to include the plural forms (or meanings) as well, unless the context clearly indicates otherwise.

Spatially relative terms, such as "beneath", "below", "lower", "above", "upper" and the like, may be used herein for ease of description to describe one element or feature's relationship to other elements or features as shown in the figures.

It will be further understood that the terms "include", "comprise", "have", and/or their variants, when used in this specification, specify the presence of stated features, integers, steps, operations, elements, and/or components, but do not preclude the presence or addition of one or more other features, integers, steps, operations, elements, components, and/or groups thereof.

The term "and/or" includes all combinations of one or more of which associated configurations may define. For example, "A and/or B" may be understood to mean "A, B, or A and B."

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. The term "overlap" or "overlapped" may mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

Unless otherwise defined or implied herein, all terms including technical and scientific terms used herein have the same meaning as commonly understood by one of ordinary skill in the art to which this disclosure pertains. It will be further understood that terms, such as those defined in commonly used dictionaries, should be interpreted as having a meaning that is consistent with their meaning in the context of the relevant art and will not be interpreted in an idealized or excessively formal sense unless expressly so defined herein.

Hereinafter, embodiments of the disclosure will be described with reference to accompanying drawings.

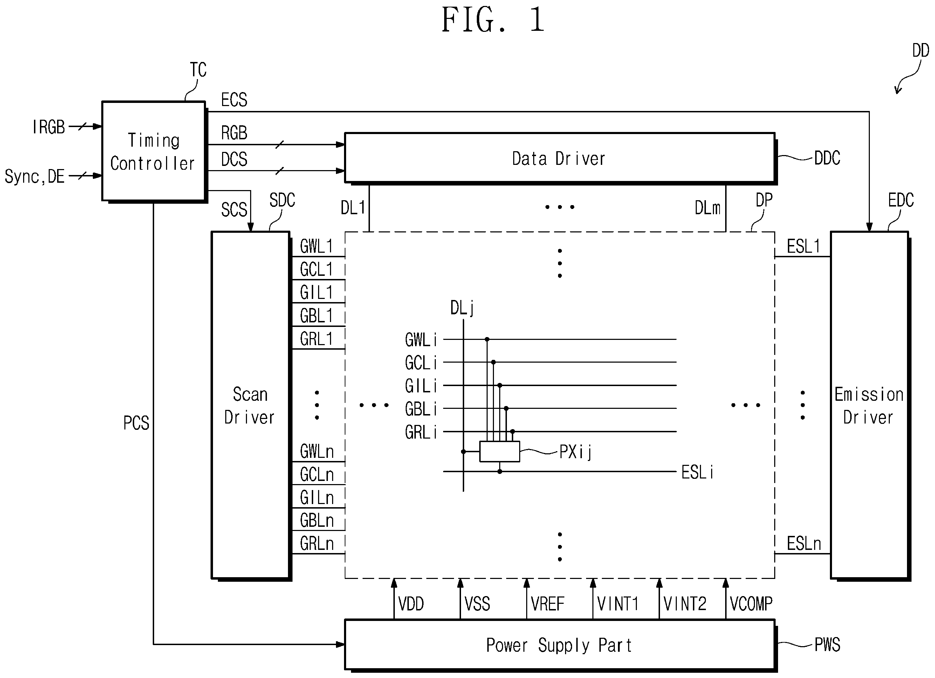

FIG. 1 is a schematic block diagram of a display device DD according to an embodiment of the disclosure.

Referring to FIG. 1, the display device DD may include a timing controller TC, a panel driver, and a display panel DP. The display panel DP may be a light-emitting type display panel. The light-emitting type display panel DP may be an organic light emitting display panel or a quantum dot light emitting display panel. The panel driver may include a scan driver SDC, an emission driver EDC, and a data driver DDC.

The display panel DP may include scan lines GWL1 to GWLn, GCL1 to GCLn, GIL1 to GILn, GBL1 to GBLn, and GRL1 to GRLn, emission lines ESL1 to ESLn, and data lines DL1 to DLm. The display panel DP may include pixels connected to the scan lines GWL1 to GWLn, GCL1 to GCLn, GIL1 to GILn, GBL1 to GBLn, and GRL1 to GRLn, the emission lines ESL1 to ESLn, and the data lines DL1 to DLm. Each of "m" and "n" is an integer number greater than 1.

As an example, a pixel PXij (where each of "i" and "j" is an integer number greater than 0) positioned to correspond to an i-th horizontal line (or an i-th pixel row) and a j-th vertical line (or a j-th pixel column) may be connected to an i-th first scan line GWLi, an i-th second scan line GCLi, an i-th third scan line GILi, an i-th fourth scan line GBLi, an i-th fifth scan line GRLi, a j-th data line DLj, and an i-th emission line ESLi.

The pixel PXij may include transistors and capacitors. The pixel PXij may receive a first power voltage (or a first driving voltage) VDD, a second power voltage (or a second driving voltage) VSS, a third power voltage (or a reference voltage) VREF, a fourth power voltage (or a first initialization voltage) VINT1, a fifth power voltage (or a second initialization voltage) VINT2, and a sixth power voltage (or a compensation voltage) VCOMP from a power supply part PWS.

The first power voltage VDD and the second power voltage VSS may have a voltage value set to allow a current to flow through a light emitting device. As an example, the first power voltage VDD may be set to have a voltage level higher than that of the second power voltage VSS.

The third power voltage VREF may be a voltage to initialize a gate of a driving transistor included in the pixel PXij. The third power voltage VREF may be used to implement a grayscale (e.g., a predetermined or selectable grayscale) using a difference in voltage between the third power voltage VREF and a data signal. To this end, the third power voltage VREF may be set to a voltage (e.g., a predetermined or selectable voltage) within a voltage range of the data signal.

The fourth power voltage VINT1 may be used to initialize a storage capacitor included in the pixel PXij. The fourth power voltage VINT1 may be set to a voltage level lower than that of the third power voltage VREF. As an example, the fourth power voltage VINT1 may be set to a voltage level lower than a difference between the third power voltage VREF and a threshold voltage (Vth) of the driving transistor. As an example, the fourth power voltage VINT1 may have a voltage level equal (or substantially equal) to or greater than about 4 volts and equal to or smaller than about 12 volts. In the case that the fourth power voltage VINT1 is set to an electric potential equal to or greater than about 4 volts, characteristics of an N-type transistor may be readily overcome, however, the disclosure should not be limited thereto or thereby.

The fifth power voltage VINT2 may be a direct current voltage. The fifth power voltage VINT2 may be used to initialize a cathode of the light emitting device included in the pixel PXij.

The sixth power voltage VCOMP may provide a current (e.g., a predetermined or selectable current) to the driving transistor in the case that the threshold voltage of the driving transistor is compensated for.

Each of the fifth and sixth power voltages VINT2 and VCOMP may be set to a voltage level lower than the first power voltage VDD or the fourth power voltage VINT1 or may be set to a voltage level similar (or close) to or equal to the third power voltage VREF, however, they should not be limited thereto or thereby. Each of the fifth and sixth power voltages VINT2 and VCOMP may be set to a voltage level similar or equal to the first power voltage VDD.

FIG. 1 illustrates a structure in which all the first, second, third, fourth, fifth, and sixth power voltages VDD, VSS, VREF, VINT1, VINT2, and VCOMP are provided from the power supply part PWS, however, the disclosure should not be limited thereto or thereby. As an example, both of the first power voltage VDD and the second power voltage VSS may be provided regardless of the structure of the pixel PXij, and at least one of the third power voltage VREF, the fourth power voltage VINT1, the fifth power voltage VINT2, and the sixth power voltage VCOMP may not be provided according to the structure of the pixel PXij.

According to the disclosure, signal lines connected to the pixel PXij may be designed in various ways by taking into account the circuit structure of the pixel PXij.

The scan driver SDC may receive a first control signal SCS from the timing controller TC and may provide a scan signal to the first scan lines GWL1 to GWLn, the second scan lines GCL1 to GCLn, the third scan lines GIL1 to GILn, the fourth scan lines GBL1 to GBLn, and the fifth scan lines GRL1 to GRLn in response to the first control signal SCS.

The scan signal may be set to a gate-on-voltage to allow the transistors to be turned on in response to the scan signal.

As an example, the scan signal provided to a PMOS (P-channel metal oxide semiconductor) transistor may be set to a logic low level, and the scan signal provided to an NMOS (N-channel metal oxide semiconductor) transistor may be set to a logic high level. Hereinafter, the expression "the scan signal is provided" may mean that the scan signal is provided to the transistor, which is controlled thereby, with a logic level that turns on the transistor.

For the convenience of explanation, FIG. 1 illustrates a scan driver SDC, however, the disclosure should not be limited thereto or thereby. According to an embodiment, the display device DD may include multiple scan drivers to provide the scan signal to the first scan lines GWL1 to GWLn, the second scan lines GCL1 to GCLn, the third scan lines GIL1 to GILn, the fourth scan lines GBL1 to GBLn, and the fifth scan lines GRL1 to GRLn, respectively.

The emission driver EDC may provide emission signals to the emission lines ESL1 to ESLn in response to a second control signal ECS. As an example, the emission signals may be sequentially provided to the emission lines ESL1 to ESLn.

Each transistor connected to the emission lines ESL1 to ESLn may be the NMOS transistor. The emission signals provided to the emission lines ESL1 to ESLn may have a gate-on voltage, e.g., the logic high level. The transistors may be turned on when receiving the emission signal and may be turned off in other cases.

The second control signal ECS may include an emission start signal and clock signals, and the emission driver EDC may be implemented by a shift register that sequentially shifts the emission start signal with a pulse shape by using the clock signals to sequentially generate and output the emission signals with a pulse shape.

The data driver DDC may receive a third control signal DCS and image data RGB from the timing controller TC. The data driver DDC may convert the image data RGB in a digital form to analog data signals. The data driver DDC may provide the data signals to the data lines DL1 to DLm in response to the third control signal DCS.

The third control signal DCS may include a data enable signal to indicate an output of an effective data signal, a horizontal start signal, and a data clock signal. As an example, the data driver DDC may include a shift register that shifts the horizontal start signal in synchronization with the data clock signal to generate a sampling signal, a latch that latches the image data RGB in response to the sampling signal, a digital-to-analog converter (or a decoder) that converts the latched image data, e.g., data in a digital form to data signals in an analog form, and buffers (or amplifiers) that output the data signals to the data lines DL1 to DLm.

The power supply part PWS may provide the first power voltage VDD, the second power voltage VSS, and the third power voltage VREF to the display panel DP to drive the pixel PXij. The power supply part PWS may provide at least one voltage of the fourth power voltage VINT1, the fifth power voltage VINT2, and the sixth power voltage VCOMP to the display panel DP.

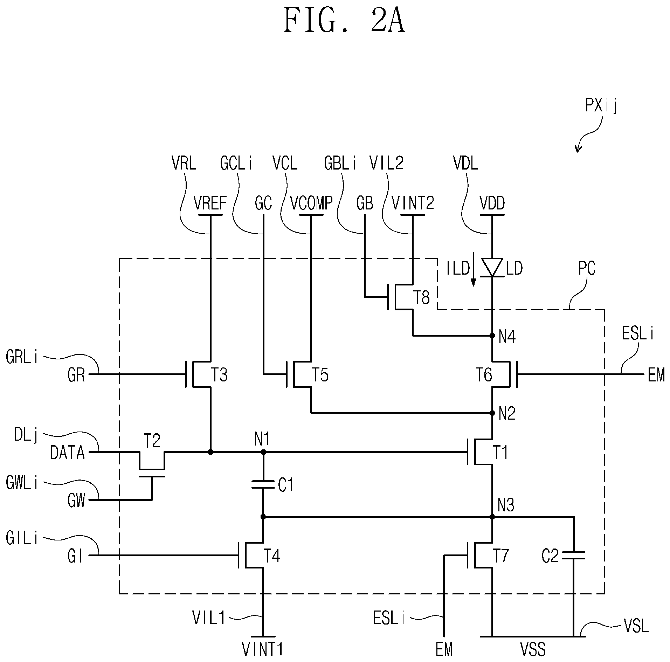

As an example, the power supply part PWS may provide the first power voltage VDD, the second power voltage VSS, the third power voltage VREF, the fourth power voltage VINT1, the fifth power voltage VINT2, and the sixth power voltage VCOMP to the display panel DP respectively via a first power line VDL (or a first driving voltage line) (see FIG. 2A), a second power line VSL (or a second driving voltage line) (see FIG. 2A), a third power line VRL (or a reference voltage line) (see FIG. 2A), a fourth power line VIL1 (or a first initialization voltage line) (see FIG. 2A), a fifth power line VIL2 (or a second initialization voltage line) (see FIG. 2A), and a sixth power line VCL (or a compensation voltage line) (see FIG. 2A).

The power supply part PWS may be implemented by a power management IC (PMIC), however, the disclosure should not be limited thereto or thereby.

The timing controller TC may generate the first control signal SCS, the second control signal ECS, the third control signal DCS, and a fourth control signal PCS based on input image data IRGB, a synchronization signal Sync, e.g., a vertical synchronization signal, a horizontal synchronization signal, etc., a data enable signal DE, and a clock signal. The first control signal SCS may be applied to the scan driver SDC, the second control signal ECS may be applied to the emission driver EDC, the third control signal DCS may be applied to the data driver DDC, and the fourth control signal PCS may be applied to the power supply part PWS. The timing controller TC may rearrange the input image data IRGB to correspond to an arrangement of the pixel PXij in the display panel DP and may generate the image data RGB (or frame data).

At least one of the scan driver SDC, the emission driver EDC, the data driver DDC, the power supply part PWS, and the timing controller TC may be formed in the display panel DP or may be connected to the display panel DP after being implemented by an integrated circuit. At least two of the scan driver SDC, the emission driver EDC, the data driver DDC, the power supply part PWS, and the timing controller TC may be implemented by a single integrated circuit. As an example, the data driver DDC and the timing controller TC may be provided as a single integrated circuit.

In the above descriptions, the display device DD is described with reference to FIG. 1, however, the display device DD should not be limited thereto or thereby. Signal lines may be added or omitted depending on the structure of the pixels. A connection relationship between a pixel and the signal lines may be changed. In the case that at least one of the signal lines is omitted, the omitted signal line may be replaced with another signal line.

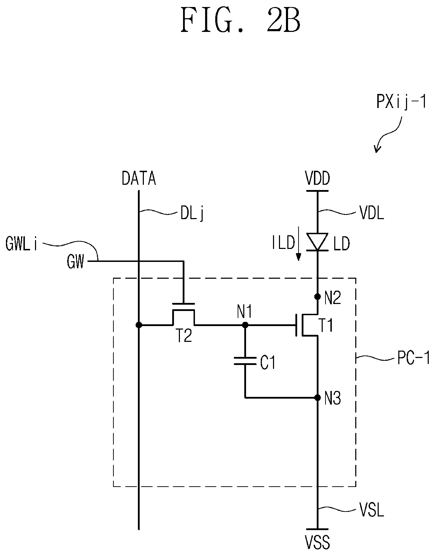

FIGS. 2A and 2B are schematic diagrams of equivalent circuits of pixels PXij and PXij-1 according to embodiments of the disclosure. FIGS. 2A and 2B illustrate the diagrams of equivalent circuits of the pixels PXij and PXij-1, which are connected to the i-th first scan line GWLi (hereinafter, referred to as a first scan line) and the j-th data line DLj (hereinafter, referred to as a data line).

Referring to FIG. 2A, the pixel PXij may include a light emitting device LD and a pixel driver PC. The light emitting device LD may be connected to the first driving voltage line VDL and the pixel driver PC.

The pixel driver PC may be connected to the scan lines GWLi, GCLi, GILi, GBLi, and GRLi, the data line DLj, the emission line ESLi, and the power lines VDL, VSL, VIL1, VIL2, VRL, and VCL. The pixel driver PC may include first, second, third, fourth, fifth, sixth, seventh, and eighth transistors T1, T2, T3, T4, T5, T6, T7, and T8, a first capacitor C1, and a second capacitor C2. Hereinafter, each of the first, second, third, fourth, fifth, sixth, seventh, and eighth transistors T1, T2, T3, T4, T5, T6, T7, and T8 will be described as an N-type transistor, however, the disclosure should not be limited thereto or thereby. According to an embodiment, some of the first to eighth transistors T1 to T8 may be an N-type transistor, and the others of the first to eighth transistors T1 to T8 may be a P-type transistor, or each of the first to eighth transistors T1 to T8 may be a P-type transistor, however, the disclosure should not be particularly limited.

A gate of the first transistor T1 may be connected to a first node N1. A first electrode of the first transistor T1 may be connected to a second node N2, and a second electrode of the first transistor T1 may be connected to a third node N3. The first transistor T1 may be a driving transistor. The first transistor T1 may control a driving current ILD flowing from the first driving voltage line VDL to the second driving voltage line VSL via the light emitting device LD in response to a voltage of the first node N1. The first driving voltage VDD may be set to a voltage with an electric potential higher than the second driving voltage VSS.

In the disclosure, the expression "the transistor is electrically connected to the signal line" may mean that a source, a drain, or a gate of the transistor is integral with the signal line, electrically connected to the signal line via a connection electrode, or directly connected to the signal line.

The second transistor T2 may include a gate connected to the first scan line GWLi, a first electrode connected to the data line DLj, and a second electrode connected to the first node N1. The second transistor T2 may provide a data signal DATA to the first node N1 via the first scan line GWLi in response to a write scan signal GW applied thereto. The second transistor T2 may be a switching transistor. The second transistor T2 may be turned on in the case that the write scan signal GW is applied to the first scan line GWLi, and thus, the data line DLj may be electrically connected to the first node N1.

The third transistor T3 may be connected between the first node N1 and the reference voltage line VRL. A first electrode of the third transistor T3 may receive the reference voltage VREF via the reference voltage line VRL, and a second electrode of the third transistor T3 may be connected to the first node N1. In the embodiment, a gate of the third transistor T3 may receive a reset scan signal GR via the i-th fifth scan line GRLi (hereinafter, referred to as a fifth scan line). The third transistor T3 may be turned on in the case that the reset scan signal GR is applied to the fifth scan line GRLi, and may provide the reference voltage VREF to the first node N1.

The fourth transistor T4 may be connected between the third node N3 and the first initialization voltage line VIL1. A first electrode of the fourth transistor T4 may be connected to the third node N3, and a second electrode of the fourth transistor T4 may be connected to the first initialization voltage line VIL1 through which the first initialization voltage VINT1 is provided. A gate of the fourth transistor T4 may receive an initialization scan signal GI via the i-th third scan line GILi (hereinafter, referred to as a third scan line). The fourth transistor T4 may be turned on in the case that the initialization scan signal GI is provided to the third scan line GILi, and may provide the first initialization voltage VINT1 to the third node N3.

The fifth transistor T5 may be connected between the compensation voltage line VCL and the second node N2. A first electrode of the fifth transistor T5 may receive the compensation voltage VCOMP via the compensation voltage line VCL, and a second electrode of the fifth transistor T5 may be connected to the second node N2 to be electrically connected to the first electrode of the first transistor T1. A gate of the fifth transistor T5 may receive a compensation scan signal GC via the i-th second scan line GCLi (hereinafter, referred to as a second scan line). The fifth transistor T5 may be turned on in the case that the compensation scan signal GC is provided to the second scan line GCLi, and may provide the compensation voltage VCOMP to the second node N2, and thus, the threshold voltage (Vth) of the first transistor T1 may be compensated for during a compensation period.

The sixth transistor T6 may be connected between the first transistor T1 and the light emitting device LD. In detail, a gate of the sixth transistor T6 may receive an emission signal EM via the i-th emission line ESLi (hereinafter, referred to as an emission line). A first electrode of the sixth transistor T6 may be connected to the cathode of the light emitting device LD via a fourth node N4, and a second electrode of the sixth transistor T6 may be connected to the first electrode of the first transistor T1 via the second node N2. The sixth transistor T6 may be referred to as a first emission control transistor. The sixth transistor T6 may be turned on in the case that the emission signal EM is provided to the emission line ESLi, and thus, the light emitting device LD may be electrically connected to the first transistor T1.

The seventh transistor T7 may be connected between the second driving voltage line VSL and the third node N3. A first electrode of the seventh transistor T7 may be connected to the second electrode of the first transistor T1 via the third node N3, and a second electrode of the seventh transistor T7 may receive the second driving voltage VSS via the second driving voltage line VSL. A gate of the seventh transistor T7 may be electrically connected to the emission line ESLi. The seventh transistor T7 may be referred to as a second emission control transistor. The seventh transistor T7 may be turned on in the case that the emission signal EM is provided to the emission line ESLi, and thus, the second electrode of the first transistor T1 may be electrically connected to the second driving voltage line VSL.

According to the embodiment, the sixth transistor T6 and the seventh transistor T7 may be connected to a same emission line ESLi and be turned on in response to a same emission signal EM, however, this is merely an example. According to an embodiment, the sixth transistor T6 and the seventh transistor T7 may be independently turned on in response to different signals distinguished from each other. According to an embodiment, at least one of the sixth transistor T6 and the seventh transistor T7 may be omitted from the pixel driver PC.

The eighth transistor T8 may be connected between the second initialization voltage line VIL2 and the fourth node N4. For example, the eighth transistor T8 may include a gate connected to the i-th fourth scan line GBLi (hereinafter, referred to as a fourth scan line), a first electrode connected to the second initialization line VIL2, and a second electrode connected to the fourth node N4. The eighth transistor T8 may provide the second initialization voltage VINT2 to the fourth node N4 corresponding to the cathode of the light emitting device LD in response to a black scan signal GB applied thereto via the fourth scan line GBLi. The cathode of the light emitting device LD may be initialized by the second initialization voltage VINT2.

According to the embodiment, some of the second, third, fourth, fifth, sixth, seventh, and eighth transistors T2, T3, T4, T5, T6, T7, and T8 may be substantially simultaneously turned on in response to a same scan signal. As an example, the eighth transistor T8 and the fifth transistor T5 may be substantially simultaneously turned on in response to a same scan signal. As an example, the eighth transistor T8 and the fifth transistor T5 may be operated in response to a same compensation scan signal GC. Since the eighth transistor T8 and the fifth transistor T5 are turned on and off in response to the same compensation scan signal GC, the eighth transistor T8 and the fifth transistor T5 may be substantially simultaneously turned on and off. The second scan line GCLi and the fourth scan line GBLi may be substantially provided as a single scan line. Accordingly, the initialization of the cathode of the light emitting device LD and the compensation of the threshold voltage of the first transistor T1 may be performed at a same timing, however, the disclosure should not be limited thereto or thereby.

According to the disclosure, the initialization of the cathode of the light emitting device LD and the compensation of the threshold voltage of the first transistor T1 may be performed in response to a same power voltage. As an example, the compensation voltage line VCL and the second initialization voltage line VIL2 may be substantially provided as a single power voltage line. The initialization operation of the cathode and the compensation operation of the driving transistor may be performed using a power voltage, and thus, a design for the drivers may be simplified. However, this is merely an example, and the disclosure should not be particularly limited.

The first capacitor C1 may be disposed between the first node N1 and the third node N3. The first capacitor C1 may be charged with a voltage corresponding to a difference between the voltage of the first node N1 and the voltage of the third node N3. The first capacitor C1 may be referred to as a storage capacitor.

The second capacitor C2 may be disposed between the third node N3 and the second driving voltage line VSL. For example, an electrode of the second capacitor C2 may be connected to the second driving voltage line VSL receiving the second driving voltage VSS, and another electrode of the second capacitor C2 may be connected to the third node N3. The second capacitor C2 may be charged with electric charges corresponding to a difference in voltage between the second power voltage VSS and the third node N3. The second capacitor C2 may be referred to as a hold capacitor. The second capacitor C2 may have a high storage capacity compared with the first capacitor C1. Accordingly, the second capacitor C2 may reduce a variation in voltage of the third node N3 according to a variation in voltage of the first node N1.

In the embodiment, the light emitting device LD may be connected to the pixel driver PC via the fourth node N4. The light emitting device LD may include an anode connected to the first driving voltage line VDL and the cathode opposite to the anode. In the embodiment, the light emitting device LD may be connected to the pixel driver PC through the cathode thereof. For example, according to the pixel PXij, a connection node at which the light emitting device LD is connected to the pixel driver PC may be the fourth node N4, and the fourth node N4 may correspond to a connection node between the first electrode of the sixth transistor T6 and the cathode of the light emitting device LD.

Accordingly, an electric potential of the fourth node N4 may correspond to an electric potential of the cathode of the light emitting device LD. For example, the anode of the light emitting device LD may be connected to the first driving voltage line VDL, so that the first driving voltage VDD that is a constant voltage may be applied to the anode, and the cathode may be electrically connected to the first transistor T1 via the sixth transistor T6, so that the electric potential of the cathode may be controlled. For example, an electric potential of the second node N2 corresponding to a source of the first transistor T1 may not be directly affected by characteristics of the light emitting device LD. Accordingly, even though the characteristics of the light emitting device LD are deteriorated due to a lifespan of the light emitting device LD, an influence of the deterioration in the characteristics of the light emitting device LD on a gate-source voltage (Vgs) of the transistors constituting the pixel driver PC, especially the driving transistor, may be reduced. For example, since a range of a change in an amount of current due to the deterioration of the light emitting device LD may be reduced, an image retention defect of the display panel according to the increase in usage time may be reduced, and a lifespan of the display panel may be improved.

As shown in FIG. 2B, the pixel PXij-1 may include a pixel driver PC-1 including two transistors T1 and T2 and a capacitor C1. The pixel driver PC-1 may be connected to a light emitting device LD, a first scan line GWLi, a data line DLj, and a second driving voltage line VSL. The pixel driver PC-1 shown in FIG. 2B may correspond to a circuit configuration obtained by removing the third to eighth transistors T3 to T8 and a second capacitor C2 from the pixel driver PC shown in FIG. 2A.

Each of the first and second transistors T1 and T2 may be an N-type transistor or a P-type transistor. In the embodiment, each of the first and second transistors T1 and T2 will be described as an N-type transistor.

The first transistor T1 may include a gate connected to a first node N1, a first electrode connected to a second node N2, and a second electrode connected to a third node N3. The second node N2 may be connected to a first driving voltage line VDL, and the third node N3 may be connected to the second driving voltage line VSL. The first transistor T1 may be connected to the light emitting device LD via the second node N2 and may be connected to the second driving voltage line VSL via the third node N3. The first transistor T1 may be a driving transistor.

The second transistor T2 may include a gate receiving a write scan signal GW via a first scan line GWLi, a first electrode connected to the data line DLj, and a second electrode connected to the first node N1. The second transistor T2 may provide a data signal DATA to the first node N1 in response to the write scan signal GW applied thereto via the first scan line GWLi.

The capacitor C1 may include an electrode connected to the first node N1 and an electrode connected to the third node N3. The capacitor C1 may be charged with the data signal DATA applied to the first node N1.

The light emitting device LD may include an anode and a cathode. In the embodiment, the anode of the light emitting device LD may be connected to the first driving voltage line VDL, and the cathode of the light emitting device LD may be connected to the pixel driver PC-1 via the second node N2. In the embodiment, the cathode of the light emitting device LD may be connected to the first transistor T1. The light emitting device LD may emit light in response to an amount of current flowing through the first transistor T1 of the pixel driver PC-1.

The second node N2 at which the cathode of the light emitting device LD is connected to the pixel driver PC-1 may correspond to a drain of the first transistor T1. The light emitting device LD may be connected to the pixel driver PC-1 via the second node N2. For example, in the pixel PXij-1 shown in FIG. 2B, a connection node at which the light emitting device LD is connected to the pixel driver PC-1 may be the second node N2, and the second node N2 may correspond to a connection node between the first electrode of the first transistor T1 and the cathode of the light emitting device LD.

For example, in the case that the driving transistor is an N-type transistor, the display panel may prevent a variation in a gate-source voltage of the first transistor T1, which is caused by the light emitting device LD. Accordingly, the range of a change in the amount of current due to deterioration of the light emitting device LD may be reduced, the image retention defect of the display panel according to the increase in usage time may be reduced, and the lifespan of the display panel may be improved.

FIGS. 2A and 2B illustrate the circuit configurations of the pixel drivers PC and PC-1 according to embodiments of the disclosure. In the disclosure, the display panel should not be particularly limited, and the number and arrangement of the transistors and the number and arrangement of the capacitors may be designed in various ways as long as a circuit is connected to the cathode of the light emitting device LD.

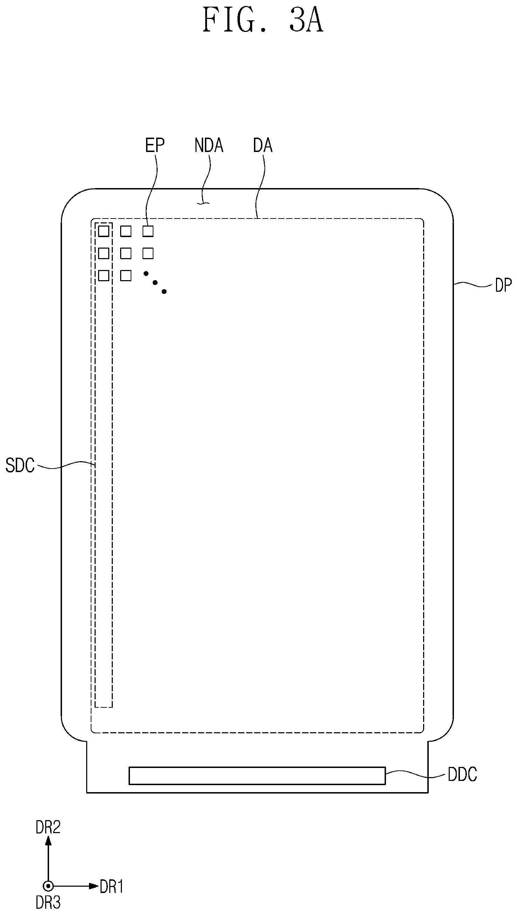

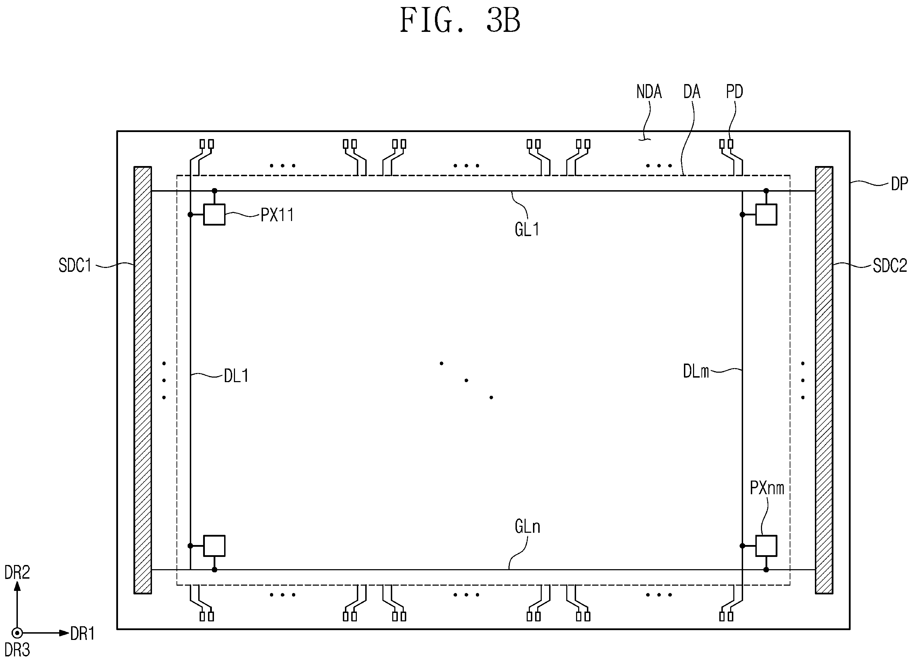

FIGS. 3A and 3B are schematic plan views of display panels DP according to embodiments of the disclosure. Hereinafter, a direction substantially perpendicular to a plane defined by a first direction DR1 and a second direction DR2 is defined as a third direction DR3. Furthermore, the expression "in plan view" used herein may mean that it is viewed in third direction DR3. In FIGS. 3A and 3B, some components may be omitted, and for the convenience of explanation, some components mounted on the display panel DP may not be omitted. Hereinafter, the disclosure will be described with reference to FIGS. 3A and 3B. Referring to FIG. 3A, the display panel DP may include a display area DA and a peripheral area NDA. The display area DA may include light emitting parts EP.

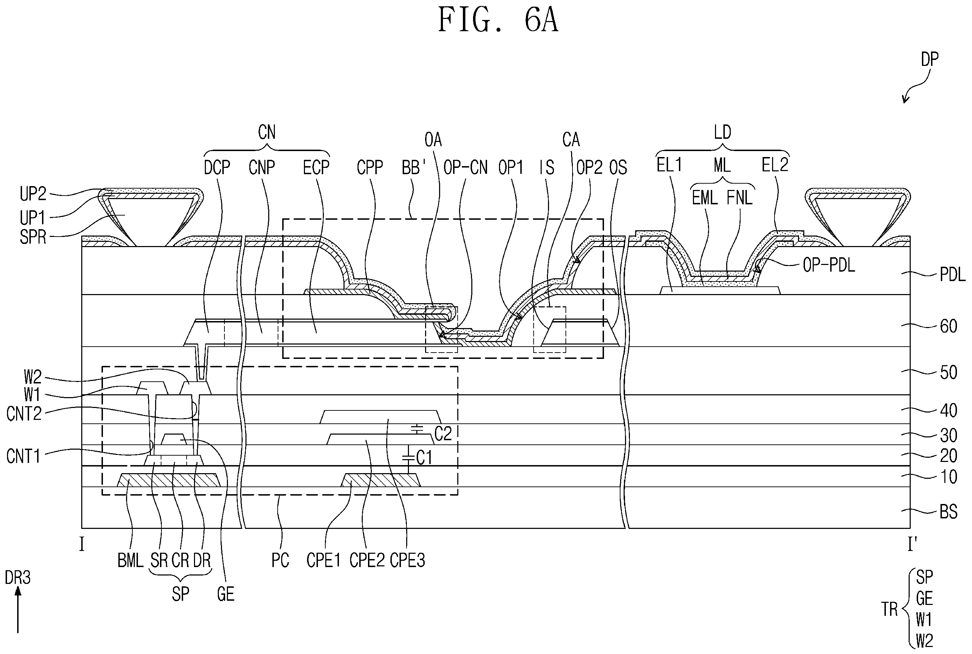

The light emitting parts EP may be areas where the pixels emit the light. In detail, each of the light emitting parts EP may correspond to a light emitting opening OP-PDL (see FIG. 6A) described below.

The peripheral area NDA may be defined adjacent to the display area DA. In the embodiment, the peripheral area NDA may have a shape surrounding an edge of the display area DA, however, this is merely an example. According to an embodiment, the peripheral area NDA may be defined adjacent to a side of the display area DA or may be omitted, but it should not be particularly limited.

In the embodiment, a scan driver SDC and a data driver DDC may be mounted on the display panel DP. The scan driver SDC may be disposed in the display area DA, and the data driver DDC may be disposed in the peripheral area NDA. The scan driver SDC may overlap at least some of the light emitting parts EP arranged in the display area DA when viewed in a plane (or in a plan view). As the scan driver SDC is disposed in the display area DA, a size of the peripheral area NDA may be reduced compared with that of a conventional display panel in which a scan driver is disposed in a peripheral area, and thus, a narrow bezel of the display device DD (see FIG. 1) may be readily implemented. However, the disclosure should not be limited thereto or thereby, and the scan driver SDC may be disposed in the peripheral area NDA.

Different from the scan driver SDC shown in FIG. 3A, the scan driver SDC may be provided in two parts distinguished from each other. The two scan drivers SDC may be respectively disposed at left and right sides of the display area DA to be spaced apart from each other with the center of the display area DA therebetween. According to an embodiment, two or more scan drivers SDC may be employed, and the number of the scan drivers SDC should not be particularly limited.

FIG. 3A illustrates a representative example of the display device DD (see FIG. 1), however, the data driver DDC may be disposed in the display area DA. In the case that the data driver DDC is disposed in the display area DA, some of the light emitting parts EP arranged in the display area DA may overlap the data driver DDC when viewed in a plane.

The data driver DDC may be provided in a separate driving chip independently formed from the display panel DP and may be connected to the display panel DP, however, this is merely an example. According to an embodiment, the data driver DDC and the scan driver SDC may be formed through a same process to form the display panel DP, and it should not be limited thereto or thereby.

Referring to FIG. 3B, the display device DD (see FIG. 1) may include the display panel DP having long sides extending in a first direction DR1. In the embodiment, the display device DD (see FIG. 1) may include pixels PX11 to PXnm and scan drivers SDC1 and SDC2. Here, n and m may be integer numbers greater than 1. The scan drivers SDC1 and SDC2 may include a first scan driver SDC1 and a second scan driver SDC2, which are spaced apart from each other in the first direction DR1.

The first scan driver SDC1 may be connected to some scan lines of scan lines GL1 to GLn, and the second scan driver SDC2 may be connected to other scan lines among the scan lines GL1 to GLn. As an example, the first scan driver SDC1 may be connected to odd-numbered scan lines among the scan lines GL1 to GLn, and the second scan driver SDC2 may be connected to even-numbered scan lines among the scan lines GL1 to GLn.

For the convenience of explanation, FIG. 3B illustrates pads PD of data lines DL1 to DLm. The pads PD may be placed at ends of the data lines DL1 to DLm. The data lines DL1 to DLm may be connected to the data driver DDC (see FIG. 3A) via the pads PD.

According to the disclosure, the pads PD may be arranged in areas of the peripheral area NDA, which are spaced apart from each other with the display area DA interposed therebetween. As an example, some pads among the pads PD may be arranged in an upper portion of the display panel DP, which is adjacent to a first scan line GL1 among the scan lines GL1 to GLn, and other pads among the pads PD may be arranged in a lower portion of the display panel DP, which is adjacent to the last scan line GLn among the scan lines GL1 to GLn. In the embodiment, pads, which are connected to odd-numbered data lines, among the pads PD may be arranged in the upper portion, and pads, which are connected to even-numbered data lines, among the pads may be arranged in the lower portion. Although not shown in the drawings, the data driver may include three upper data drivers connected to the pads PD arranged in the upper portion and three lower data drivers connected to the pads PD arranged in the lower portion, however, these are merely examples. According to an embodiment, the pads PD may be connected to two data drivers arranged in the upper and lower portions. According to an embodiment, the pads PD may be arranged in a side and may be connected to a single data driver, however, the disclosure should not be particularly limited.

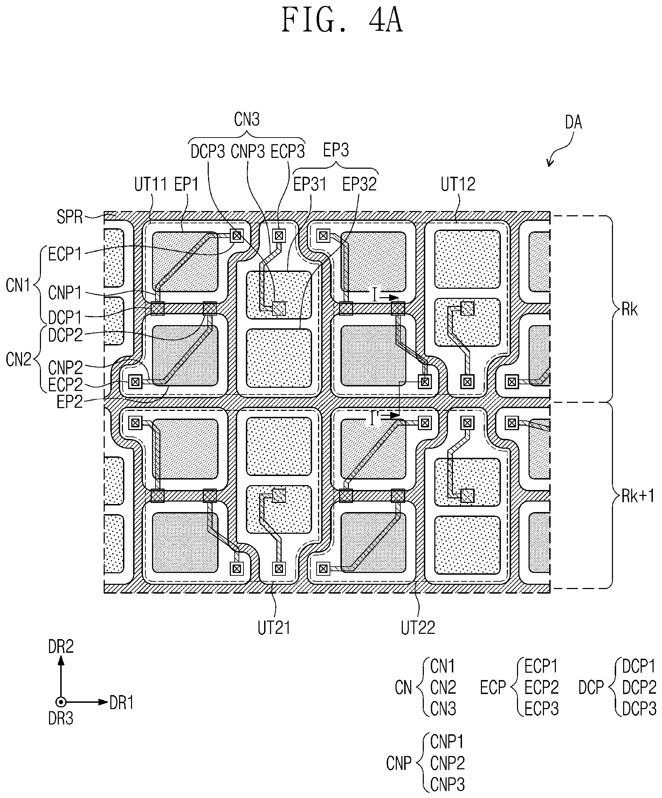

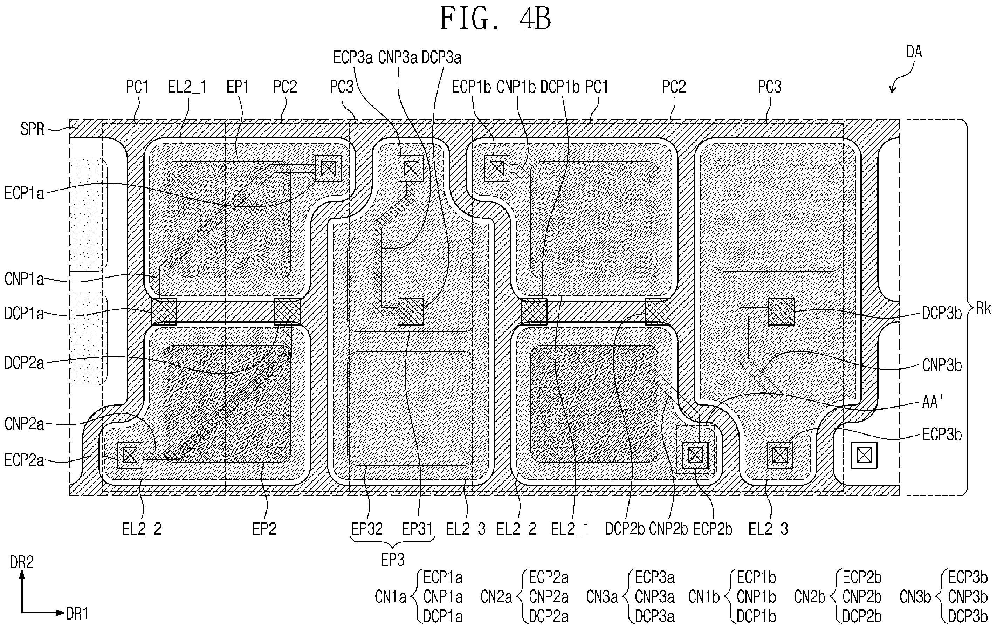

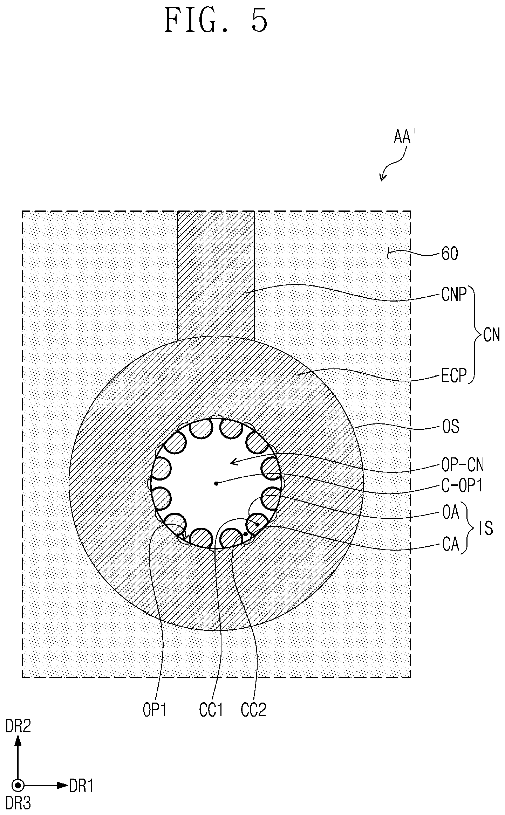

FIGS. 4A to 4C are schematic enlarged plan views of some areas of the display area according to an embodiment of the disclosure. FIG. 5 is a schematic enlarged plan view of area AA' of a display area of FIG. 4B according to an embodiment of the disclosure.

FIG. 4A illustrates light emitting units UT11, UT12, UT21, and UT22 arranged in two rows and two columns. The light emitting parts arranged in a first row Rk may include light emitting parts forming (or constituting) the light emitting unit UT11 (hereinafter, also be referred to as a first-row first-column light emitting unit) arranged in a first row Rk and a first column and the light emitting unit UT12 (hereinafter, also be referred to as a first-row second-column light emitting unit) arranged in the first row Rk and a second column, and the light emitting parts arranged in a second row Rk+1 may include light emitting parts forming the light emitting unit UT21 (hereinafter, also be referred to as a second-row first-column light emitting unit) arranged in a second row Rk+1 and the first column and the light emitting unit UT22 (hereinafter, also be referred to as a second-row second-column light emitting unit) arranged in the second row Rk+1 and the second column. FIGS. 4A to 4C illustrate a separator SPR, light emitting parts EP1, EP2, and EP3 disposed in areas divided by the separator SPR, connection wirings CN1, CN2, and CN3, an anode (or a first electrode) EL1, and cathodes (or second electrodes) EL2_1, EL2_2, and EL2_3 among components of the display panel DP (see FIG. 1).

As described above, each of the light emitting parts EP1, EP2, and EP3 may correspond to the light emitting opening OP-PDL (see FIG. 6A) described below. For example, each of the light emitting parts EP1, EP2, and EP3 may be an area from which the light is emitted by the light emitting device LD (see FIG. 2A or 2B) and may correspond to a unit providing the image displayed through the display panel DP.

The light emitting parts EP1, EP2, and EP3 may include a first light emitting part EP1, a second light emitting part EP2, and a third light emitting part EP3. The first light emitting part EP1, the second light emitting part EP2, and the third light emitting part EP3 may emit rays of light having different colors. As an example, the first light emitting part EP1 may emit red light, the second light emitting part EP2 may emit green light, and the third light emitting part EP3 may emit blue light, however, a combination of colors of the first, second, and third light emitting parts EP1, EP2, and EP3 should not be limited thereto or thereby.

Among the light emitting parts EP1, EP2, and EP3, the third light emitting part EP3 may include two sub-light emitting parts EP31 and EP32 spaced apart from each other in a second direction DR2, however, this is merely an example. According to an embodiment, the third light emitting part EP3 may be provided in a single pattern having an integral shape, similar to the other light emitting parts EP1 and EP2, or at least one of the other light emitting parts EP1 and EP2 may include sub-light emitting parts, and the disclosure should not be particularly limited.

In the embodiment, the light emitting parts EP arranged in the first row Rk may include light emitting parts EP in a structure in which the light emitting unit UT11 arranged in the first row Rk and the first column and the light emitting unit UT12 arranged in the first row Rk and the second column are repeatedly and alternately arranged with each other. The light emitting parts EP arranged in the second row Rk+1 may include light emitting parts EP in a structure in which the light emitting unit UT21 arranged in the second row and the first column Rk+1 and the light emitting unit UT22 arranged in the second row Rk+1 and the second column are repeatedly and alternately arranged with each other. The shape and the arrangement of the third light emitting part EP3 forming the light emitting unit UT11 may be axisymmetric with that of the third emitting part EP3 forming the light emitting unit UT21 with respect to the axis parallel to the first direction DR1. The shape and the arrangement of the third light emitting part EP3 forming the light emitting unit UT12 may be axisymmetric with that of the third emitting part EP3 forming the light emitting unit UT22 with respect to the axis parallel to the first direction DR1.

Hereinafter, the light emitting unit UT11 arranged in the first row Rk and the first column will be described in detail. For the convenience of explanation, FIG. 4B illustrates the cathodes EL2_1, EL2_2, and EL2_3, pixel drivers PC1, PC2, and PC3, and the connection wirings CN1, CN2, and CN3. The cathodes EL2_1, EL2_2, and EL2_3 may be separated from each other by the separator SPR. In the embodiment, a light emitting part EP, e.g., the light emitting unit UT11 arranged in the first row Rk and the first column, may include three light emitting parts EP1, EP2, and EP3. Accordingly, a light emitting part EP may include three cathodes EL2_1, EL2_2, and EL2_3 (hereinafter, referred to as first, second, and third cathodes), three pixel drivers PC1, PC2, and PC3 (hereinafter, referred to as first, second, and third pixel drivers), and three connection wirings CN1, CN2, and CN3, however, this is merely an example. According to an embodiment, the number and arrangement of the light emitting units UT11, UT12, UT21, and UT22 may be designed in various ways and should not be particularly limited.

The first, second, and third pixel drivers PC1, PC2, and PC3 may be respectively connected to the light emitting devices forming the first, second, and third light emitting parts EP1, EP2, and EP3. In the disclosure, the expression that component A is connected to component B may mean not only a case where component A is directly and physically connected or extended to component B, but also a case where component A is electrically connected to component B.

The first, second, and third pixel drivers PC1, PC2, and PC3 may be sequentially arranged in the first direction DR1. The arrangement positions of the first, second, and third pixel drivers PC1, PC2, and PC3 may be designed independently from positions and shapes of the first, second, and third light emitting parts EP1, EP2, and EP3.

As an example, the first, second, and third pixel drivers PC1, PC2, and PC3 may be placed at positions different from the areas divided by the separator SPR, e.g., positions at which the first, second, and third cathodes EL2_1, EL2_2, and EL2_3 are placed, or may be designed to have shapes and sizes different from the shapes and sizes of the first, second, and third cathodes EL2_1, EL2_2, and EL2_3. According to an embodiment, the first, second, and third pixel drivers PC1, PC2, and PC3 may be placed to respectively overlap the positions at which the first, second, and third light emitting parts EP1, EP2, and EP3 are placed, and may be designed to have shapes and sizes similar to those of the areas divided by the separator SPR, e.g., shapes and sizes of the first, second, and third cathodes EL2_1, EL2_2, and EL2_3.

In the embodiment, each of the first, second, and third pixel drivers PC1, PC2, and PC3 may have a rectangular shape, the first, second, and third light emitting parts EP1, EP2, and EP3 may be arranged in different arrangements, and the first, second, and third cathodes EL2_1, EL2_2, and EL2_3 may be placed at positions overlapping the first, second, and third light emitting parts EP1, EP2, and EP3 and may have an atypical shape.

Accordingly, as shown in FIG. 4B, the first pixel driver PC1 may be placed at a position overlapping the first light emitting part EP1, the second light emitting part EP2, and a portion of another light emitting unit adjacent thereto. The second pixel driver PC2 may be placed at a position overlapping the first light emitting part EP1, the second light emitting part EP2, and the third light emitting part EP3. The third pixel driver PC3 may be placed at a position overlapping the third light emitting part EP3, however, these are merely examples. According to an embodiment, the positions of the first, second, and third pixel drivers PC1, PC2, and PC3 may be designed to have various shapes and arrangements independent of the first, second and third light emitting parts EP1, EP2, and EP3 and should not be particularly limited.

A connection wiring CN may be provided in plural, and the connection wirings CN may be arranged spaced apart from each other. The connection wirings CN may electrically connect the pixel drivers PC1, PC2, and PC3 and the light emitting devices, respectively. In detail, each of the connection wirings CN may correspond to the node (the fourth node N4 of FIG. 2A or the second node N2 of FIG. 2B) at which the light emitting device LD is connected to the pixel driver PC or PC-1.

Each of the connection wirings CN may include a first connection part ECP (hereinafter, referred to as an emission connection part), a second connection part DCP (hereinafter, referred to as a driver connection part), and a connection part CNP. Each of the emission connection parts ECP may be connected to an end of a corresponding connection part CNP, and each of the driver connection parts DCP may be connected to another end of the connection part CNP.

The driver connection part DCP may be a portion of the connection wiring CN, which is connected to a corresponding pixel driver PC1, PC2, or PC3. In the embodiment, the driver connection part DCP may be connected to an electrode of a transistor forming the pixel driver PC1, PC2, or PC3. In detail, the driver connection part DCP may be connected to a drain of the sixth transistor T6 shown in FIG. 2A or the drain of the first transistor T1 shown in FIG. 2B. Accordingly, a position of the driver connection part DCP may correspond to a position of a transistor TR (see FIG. 6A) of the corresponding pixel driver PC1, PC2, or PC3, which is physically connected to the connection wiring CN.

The emission connection part ECP may provide a portion of the connection wiring CN, which is connected to a corresponding light emitting device. In the embodiment, the emission connection part ECP may be connected to the cathode EL2_1, EL2_2, or EL2_3 of the corresponding light emitting device.

A light emitting part EP may include first, second, and third connection wirings CN1, CN2, and CN3. The first connection wiring CN1 may connect the light emitting device forming the first light emitting part EP1 to the first pixel driver PC1, the second connection wiring CN2 may connect the light emitting device forming the second light emitting part EP2 to the second pixel driver PC2, and the third connection wiring CN3 may connect the light emitting device forming the third light emitting part EP3 to the third pixel driver PC3.

In detail, the first, second, and third connection wirings CN1, CN2, and CN3 may connect the first, second, and third cathodes EL2_1, EL2_2, and EL2_3 to the first, second, and third pixel drivers PC1, PC2, and PC3, respectively.

The first connection wiring CN1 may include a first emission connection part ECP1 connected to the first cathode EL2_1, a first driver connection part DCP1 connected to the first pixel driver PC1, and a first connection part CNP1 extending from the first emission connection part ECP1 to the first driver connection part DCP1.

The second connection wiring CN2 may include a second emission connection part ECP2 connected to the second cathode EL2_2, a second driver connection part DCP2 connected to the second pixel driver PC2, and a second connection part CNP2 extending from the second emission connection part ECP2 to the second driver connection part DCP2.

The third connection wiring CN3 may include a third emission connection part ECP3 connected to the third cathode EL2_3, a third driver connection part DCP3 connected to the third pixel driver PC3, and a third connection part CNP3 extending from the third emission connection part ECP3 to the third driver connection part DCP3.

The first, second, and third driver connection parts DCP1, DCP2, and DCP3 may be arranged in the first direction DR1. As described above, positions of the first, second, and third driver connection parts DCP1, DCP2, and DCP3 may respectively correspond to positions of connection transistors forming the first, second, and third pixel drivers PC1, PC2, and PC3, e.g., a position of the sixth transistor T6 of FIG. 2A or the first transistor T1 of FIG. 2B. According to the disclosure, as the pixel driver may be designed identically for all pixels regardless of the shape or size of the light emitting part EP and emission colors, a manufacturing process of the display panel may be simplified, and a manufacturing cost of the display panel may be reduced.

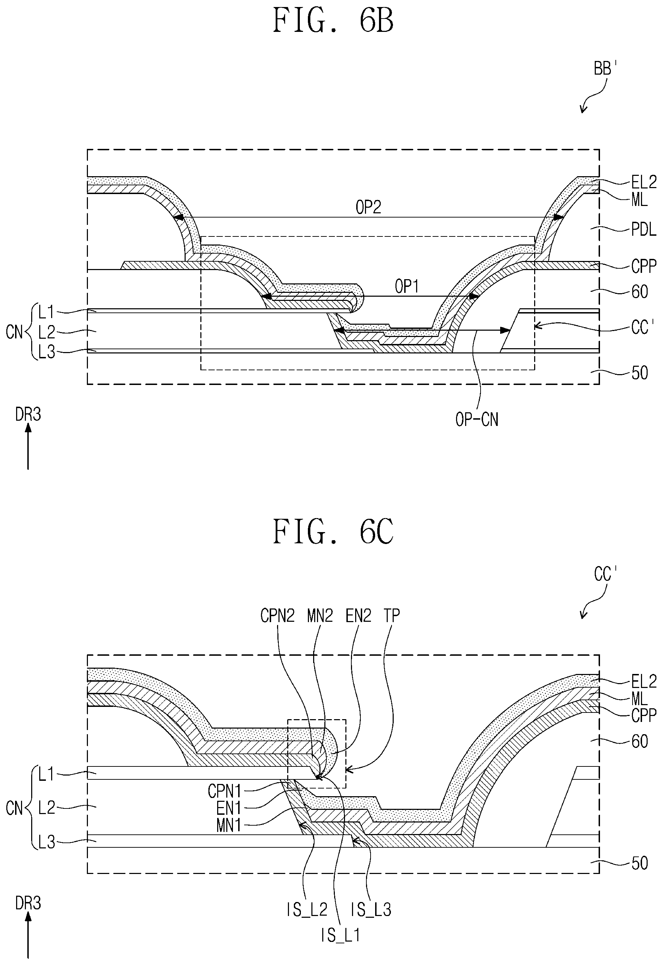

In the embodiment, the first, second, and third emission connection parts ECP1, ECP2, and ECP3 may be defined at positions that do not overlap the light emitting parts EP1, EP2, and EP3 when viewed in a plane. Since each of the emission connection parts ECP1, ECP2, and ECP3 may include a portion to which the light emitting device is connected and a portion in which a tip part TP (see FIG. 6C) is defined, each of the emission connection parts ECP1, ECP2, and ECP3 may be provided at the position that does not overlap the light emitting opening OP-PDL (see FIG. 6A) corresponding to an area in which the image corresponding to the provided light is displayed. For example, the emission connection parts ECP1, ECP2, and ECP3 may be placed at the positions spaced apart from the light emitting parts EP1, EP2, and EP3 in the cathodes EL2_1, EL2_2, and EL2_3, and the cathodes EL2_1, EL2_2, and EL2_3 may include some areas protruded from the light emitting parts EP1, EP2, and EP3 when viewed in a plane to be connected to the connection wirings CN1, CN2, and CN3 at positions where the emission connection parts ECP1, ECP2, and ECP3 are placed.

As an example, the first cathode EL2_1 may include a protruding portion protruded from the first light emitting part EP1 at the position that does not overlap the first light emitting part EP1 to be connected to the first connection wiring CN1 at the position where the first emission connection part ECP1 is placed. The first emission connection part ECP1 may be provided in the protruding portion. Accordingly, the first cathode EL2_1 may be connected to the first connection wiring CN1 without reducing a light emitting area of the first light emitting part EP1.

In the first pixel driver PC1, the first driver connection part DCP1 that is at a position where the transistor is connected may be defined at a position that does not overlap the first light emitting part EP1 when viewed in a plane. According to the embodiment, as the first connection wiring CN1 is disposed in the first light emitting part EP1, the first cathode EL2_1 may be readily connected to the first pixel driver PC1.

In the third pixel driver PC3, the third driver connection part DCP3 that is at a position connected to the transistor may be defined at a position that does not overlap the third emission connection part ECP3 when viewed in a plane and may be placed at a position overlapping the third light emitting part EP3. According to the embodiment, as the third cathode EL2_3 is connected to the third pixel driver PC3 via the third connection wiring CN3, the third pixel driver PC3 may be readily connected to the third cathode EL2_3 even though the third driver connection part DCP3 overlaps the third light emitting part EP3 when viewed in a plane. Accordingly, restrictions on the design of pixel driver PC3 due to the position or shape of the third light emitting part EP3 may be reduced, and the degree of freedom in circuit design may be improved.

The extension direction and/or the shape of the first, second, and third connection parts CNP1, CNP2, and CNP3 should not be limited thereto or thereby. The extension direction and/or the shape of the first, second, and third connection parts CNP1, CNP2, and CNP3 should not be particularly limited as long as the first, second, and third connection parts CNP1, CNP2, and CNP3 extend from the emission connection parts ECP1, ECP2, and ECP3 to the driver connection parts DCP1, DCP2, and DCP3 and provide paths through which the emission connection parts ECP1, ECP2, and ECP3 are connected to the driver connection parts DCP1, DCP2, and DCP3.

The shape and the arrangement of the first and second light emitting parts EP1 and EP2 constituting the light emitting unit UT11 may be axisymmetric with that of the first and second light emitting parts EP1 and EP2 constituting the light emitting unit UT12 with respect to the axis parallel to the second direction DR2. The shape and the arrangement of the third light emitting part EP3 forming the light emitting unit UT11 may be axisymmetric with that of the third emitting part EP3 forming the light emitting unit UT12 with respect to the axis parallel to the first direction DR1 (or, symmetrical vertically based on the second direction DR2). Due to the relationship of the light emitting units UT11 and UT12 arranged in the first row Rk, the light emitting units UT21 and UT22 arranged in the second row Rk+1 may include the light emitting parts EP obtained by shifting the light emitting units UT11 and UT12 arranged in the first row Rk in the first direction DR1. For example, the light emitting unit UT21 arranged in the second row Rk+1 and the first column may include the light emitting parts EP having the same shape as that of the light emitting parts EP included in the light emitting unit UT12 arranged in the first row Rk and the second column, and the light emitting unit UT22 arranged in the second row Rk+1 and the second column may include the light emitting parts EP having the same shape as that of the light emitting parts EP included in the light emitting unit UT11 arranged in the first row Rk and the first column.

According to the embodiment, the connection wirings CN may include first group connection wirings CN1a, CN2a, and CN3a and second group connection wirings CN1b, CN2b, and CN3b. The connection wirings CN arranged in the first-row first-column light emitting unit UT11 and the connection wirings arranged in the second-row second-column light emitting unit UT22 may have a shape and arrangement of the first group connection wirings CN1a, CN2a, and CN3a, and the connection wirings CN arranged in the first-row second-column light emitting unit UT12 and the connection wirings CN arranged in the second-row first-column light emitting unit UT21 may have a shape and arrangement of the second group connection wirings CN1b, CN2b, and CN3b.

A first connection wiring CN1a of a first group may include a first-first emission connection part ECP1a, a first-first driver connection part DCP1a, and a first-first connection part CNP1a, a second connection wiring CN2a of the first group may include a second-first emission connection part ECP2a, a second-first driver connection part DCP2a, and a second-first connection part CNP2a, and a third connection wiring CN3a of the first group may include a third-first emission connection part ECP3a, a third-first driver connection part DCP3a, and a third-first connection part CNP3a.

A first connection wiring CN1b of a second group may include a first-second emission connection part ECP1b, a first-second driver connection part DCP1b, and a first-second connection part CNP1b, a second connection wiring CN2b of the second group may include a second-second emission connection part ECP2b, a second-second driver connection part DCP2b, and a second-second connection part CNP2b, and a third connection wiring CN3b of the second group may include a third-second emission connection part ECP3b, a third-second driver connection part DCP3b, and a third-second connection part CNP3b.

The first-first emission connection part ECP1a, the third-first emission connection part ECP3a, and the first-second emission connection part ECP1b may be adjacent to each other and may be arranged in the first direction DR1. When viewed in a plane, the third-first emission connection part ECP3a may be spaced apart from a corresponding third light emitting part EP3 in the second direction DR2 (e.g., a direction from the second row Rk+1 toward the first row Rk). When viewed in a plane, the first-first emission connection part ECP1a may be disposed between the third-first emission connection part ECP3a and a corresponding first light emitting part EP1, and the first-second emission connection part ECP1b may be disposed between the third-first emission connection part ECP3a and a corresponding first light emitting part EP1.

The second-second emission connection part ECP2b, the third-second emission connection part ECP3b, and the second-first emission connection part ECP2a may be adjacent to each other and may be arranged in the first direction DR1. When viewed in a plane, the third-second emission connection part ECP3b may be spaced apart from a corresponding third light emitting part EP3 in the second direction DR2 (e.g., a direction opposite to the second direction DR2, or a direction from the first row Rk toward the second row Rk+1). When viewed in a plane, the second-second emission connection part ECP2b may be disposed between the third-second emission connection part ECP3b and a corresponding second light emitting part EP2, and the second-first emission connection part ECP2a may be disposed between the third-second emission connection part ECP3b and a corresponding second light emitting part EP2.

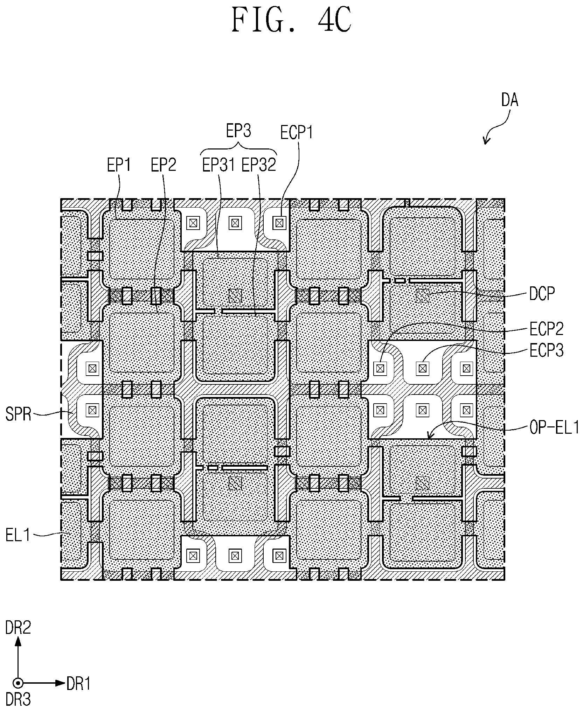

Referring to FIG. 4C, the anode EL1 may be commonly disposed in the light emitting parts EP1, EP2, and EP3. For example, the anode EL1 may have an integral shape and may be disposed to overlap the light emitting parts EP1, EP2, and EP3 or the separator SPR. The first power voltage VDD (see FIG. 2A) may be applied to the anode EL1, and a common voltage may be applied to all the light emitting parts EP1, EP2, and EP3. The anode EL1 may be connected to the first power line VDL (see FIG. 2A) providing the first power voltage VDD (see FIG. 2A) in the peripheral area NDA (see FIG. 3A) or may be connected to the first power line VDL (see FIG. 2A) in the display area DA (see FIG. 3A), and it should not be limited thereto or thereby.

Openings OP-EL1 may be defined through the anode EL1, and the openings OP-EL1 may penetrate through the anode EL1. The openings OP-EL1 may be defined at positions that do not overlap the light emitting parts EP1, EP2, and EP3 and may be defined to overlap the separator SPR. The openings OP-EL1 may facilitate a discharge of a gas generated from an organic layer disposed under the anode EL1, e.g., a sixth insulating layer 60 (see FIG. 6A). Accordingly, deterioration of the light emitting device, which is caused by the gas generated from the organic layer, may be improved.

According to the disclosure, different from the light emitting parts in which the cathode overlaps the connection transistor of the pixel driver when viewed in a plane, the light emitting parts including the cathode having the shape that does not overlap the connection transistor of the pixel driver may be readily connected to the pixel driver since the display panel further includes the connection wiring. According to the disclosure, as the display panel further includes the connection wiring, the light emitting device may be stably connected to the pixel driver by changing only the shape of the cathode without changing the design of the light emitting parts. Accordingly, the influence of the arrangement or shape of the light emitting parts on the connection between the light emitting device and the pixel driver may be reduced, a degree of freedom in designing the pixel driver may be improved, and deterioration in aperture ratio of the light emitting part may be prevented.

FIG. 5 is a schematic enlarged plan view of the emission connection part ECP and a portion of the connection part CNP adjacent thereto of a connection wiring CN. The emission connection part ECP and the connection part CNP shown in FIG. 5 may respectively correspond to the second-second emission connection part ECP2b and the second-second connection part CNP2b of FIG. 4B. Details on the emission connection part ECP and the connection part CNP described with reference to FIG. 5 may be substantially equally applicable to the other emission connection parts and the other connection parts of FIG. 4B.

Referring to FIG. 5, a line opening OP-CN may be defined through the emission connection part ECP. The emission connection part ECP may include an inner side surface IS defining the line opening OP-CN and an outer side surface OS opposite to the inner side surface IS.

The outer side surface OS of the emission connection part ECP may have a circular shape when viewed in a plane, however, the shape of the outer side surface OS should not be limited to the circular shape. According to an embodiment, the outer side surface OS may have a polygonal shape.

The inner side surface IS of the emission connection part ECP may include opening portions OA (or first portions) and cover portions CA (or second portions). In the inner side surface IS of FIG. 5, the opening portions OA are shown by a relatively bold line. The opening portions OA may be alternately arranged with the cover portions CA. The opening portions OA and the cover portions CA may be arranged along an imaginary line with a circular shape.

In the embodiment, each of the opening portions OA and each of the cover portions CA may have a curvature. Each of the opening portions OA may have the curvature to allow a curvature center CC1 to be defined inside the emission connection part ECP. Each of the cover portions CA may have the curvature to allow a curvature center CC2 to be defined outside the emission connection part ECP (or inside the line opening OP-CN).

FIG. 5 illustrates the insulating layer 60 disposed at an upper side of the connection wiring CN. In the embodiment, a first opening OP1 may be defined through the insulating layer 60. The first opening OP1 may have a circular shape when viewed in a plane.

According to the embodiment, the opening portions OA may overlap the first opening OP1 and may be exposed by the first opening OP1 without being covered by the insulating layer 60. The cover portions CA may overlap the insulating layer 60. For example, the cover portions CA may be covered by the insulating layer 60.

The opening portions OA may be alternately arranged with the cover portions CA along a boundary of the first opening OP1. When viewed in a plane, the opening portions OA may be disposed at an inner side with respect to the boundary of the first opening OP1, the cover portions CA may be disposed at an outer side with respect to the boundary of the first opening OP1, and the opening portions OA may be closer to a center C-OP1 of the first opening OP1 than the cover portions CA.

The shape of the first opening OP1 in a plane should not be particularly limited, and the first opening OP1 may have a polygonal shape in a plane as long as the opening portions OA and the cover portions CA are alternately arranged with each other in the emission connection part ECP. As shown in FIG. 5, the connection part CNP may extend from a corresponding emission connection part ECP. In other words, the emission connection part ECP may be connected to an end of the connection part CNP.

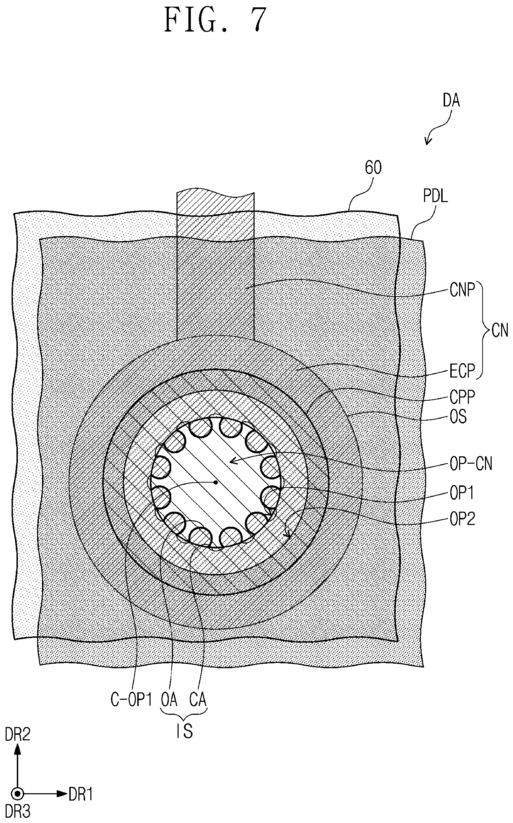

FIG. 6A is a schematic enlarged cross-sectional view of the display panel DP taken along line I-I' of FIG. 4A according to an embodiment of the disclosure. FIG. 6B is a schematic enlarged plan view of area BB' of the display panel DP of FIG. 6A according to an embodiment of the disclosure. FIG. 6C is a schematic enlarged plan view of area CC' of the display panel DP of FIG. 6B according to an embodiment of the disclosure. FIG. 7 is a schematic enlarged plan view of a portion of a display area DA according to an embodiment of the disclosure.

Referring to FIG. 6A, the display panel DP may include a base layer BS, insulating layers 10, 20, 30, 40, 50, 60, PDL, and SPR disposed on the base layer BS, and conductive patterns and semiconductor patterns which are disposed between the insulating layers 10, 20, 30, 40, 50, 60, PDL, and SPR. The conductive patterns and the semiconductor patterns may be disposed between the insulating layers 10, 20, 30, 40, 50, 60, PDL, and SPR and may form the pixel driver PC, the connection wiring CN, and the light emitting device LD. For the convenience of explanation, FIG. 6A illustrates a cross-section of a portion of an area in which a light emitting part EP and a connection wiring CN are disposed.

The base layer BS may provide a base surface on which the pixel driver PC is disposed. The base layer BS may be a rigid substrate or a flexible substrate that is bendable, foldable, and/or rollable. The base layer BS may be, e.g., a glass substrate, a metal substrate, or a polymer substrate, however, it should not be limited thereto or thereby. According to an embodiment, the base layer BS may be an inorganic layer, an organic layer, or a composite material layer.

The base layer BS may have a multi-layer structure. For instance, the base layer BS may include a first polymer resin layer, a silicon oxide (SiOx) layer disposed on the first polymer resin layer, an amorphous silicon (a-Si) layer disposed on the silicon oxide layer, and a second polymer resin layer disposed on the amorphous silicon (a-Si) layer. The silicon oxide (SiOx) layer and the amorphous silicon (a-Si) layer may be referred to as a base barrier layer.

Each of the first and second polymer resin layers may include a polyimide-based resin. Each of the first and second polymer resin layers may include, e.g., at least one of an acrylic-based resin (e.g., a methacrylic-based resin), a polyisoprene-based resin, a vinyl-based resin, an epoxy-based resin, a urethane-based resin, a cellulose-based resin, a siloxane-based resin, a polyamide-based resin, and a perylene-based resin. In the disclosure, the term "X-based resin", as used herein, refers to the resin that includes a functional group of X.

The insulating layers, conductive layers, and semiconductor layers, which are disposed on the base layer BS, may be formed through coating and deposition processes. The insulating layer, the conductive layers, and the semiconductor layers may be selectively patterned through several photolithography processes, and thus, holes may be defined through the insulating layers, or the semiconductor pattern, the conductive pattern, and the signal line may be formed.

The display panel DP may include first, second, third, fourth, fifth, and sixth insulating layers 10, 20, 30, 40, 50, and 60 sequentially stacked on the base layer BS and the pixel driver PC. FIG. 6A illustrates a transistor TR and two capacitors C1 and C2 of the pixel driver PC. The transistor TR may correspond to a transistor connected to the light emitting device LD via the connection wiring CN, e.g., the connection transistor connected to the node (the fourth node N4 of FIG. 2A or the second node N2 of FIG. 2B) corresponding to a second electrode EL2 of the light emitting device LD. In detail, the transistor TR may correspond to the sixth transistor T6 of FIG. 2A or the first transistor T1 of FIG. 2B. The second electrode EL2 of FIG. 6A corresponds to the second cathode EL2_2 of FIG. 4B as an example, and the description of the second electrode EL2 of FIG. 6A may be similarly applied to the first and third cathodes EL2_1 and EL2_3 of FIG. 4B. Although not shown in the drawings, other transistors forming the pixel driver PC and the transistor TR (hereinafter referred to as the connection transistor) shown in FIG. 6A may have substantially a same structure, however, this is merely an example. According to an embodiment, other transistors forming the pixel driver PC and the connection transistor TR may have different structures, and the structure of the other transistors should not be particularly limited thereto.

The first insulating layer 10 may be disposed on the base layer BS. The first insulating layer 10 may be an inorganic layer and/or an organic layer and may have a single-layer or multi-layer structure. The first insulating layer 10 may include at least one of aluminium oxide, titanium oxide, silicon oxide, silicon nitride, silicon oxynitride, zirconium oxide, and hafnium oxide. In the embodiment, the first insulating layer 10 may have a single-layer structure of a silicon oxide layer. Insulating layers described below may be an inorganic layer and/or an organic layer and may have a single-layer or multi-layer structure. The inorganic layer may include at least one of the above-mentioned materials, however, it should not be limited thereto or thereby.

The first insulating layer 10 may cover a bottom conductive layer BML. For example, the display panel may further include the bottom conductive layer BML disposed under the connection transistor TR and overlapping the connection transistor TR. The bottom conductive layer BML may prevent an electric potential caused by a polarization phenomenon of the base layer BS from exerting influence on the connection transistor TR. The bottom conductive layer BML may block light incident into the connection transistor TR from a lower side of the bottom conductive layer BML. At least one of an inorganic barrier layer and a buffer layer may be further disposed between the bottom conductive layer BML and the base layer BS.

The bottom conductive layer BML may include a reflective metal material. As an example, the bottom conductive layer BML may include at least one of titanium (Ti), molybdenum (Mo), an alloy including molybdenum (Mo), aluminium (Al), an alloy including aluminium (Al), aluminium nitride (AlN), tungsten (W), tungsten nitride (WN), and copper (Cu).

In the embodiment, the bottom conductive layer BML may be connected to a source of the connection transistor TR via a source electrode pattern W1. The bottom conductive layer BML may be synchronized with the source of the connection transistor TR, however, this is merely an example. According to an embodiment, the bottom conductive layer BML may be connected to and synchronized with a gate of the connection transistor TR. According to an embodiment, the bottom conductive layer BML may be connected to another electrode to independently receive a constant voltage or a pulse signal. According to an embodiment, the bottom conductive layer BML may be provided in an isolated form isolated from other conductive patterns. The bottom conductive layer BML may be provided in a variety of shapes and should not be particularly limited.

The connection transistor TR may be disposed on the first insulating layer 10. The connection transistor TR may include a semiconductor pattern SP and a gate electrode GE. The semiconductor pattern SP may be disposed on the first insulating layer 10. The semiconductor pattern SP may include an oxide semiconductor. As an example, the oxide semiconductor may include a transparent conductive oxide (TCO), such as indium tin oxide (ITO), indium zinc oxide (IZO), indium gallium zinc oxide (IGZO), zinc oxide (ZnO), indium oxide (In₂O₃), or the like, however, the material for the semiconductor pattern SP should not be limited thereto or thereby. As an example, the semiconductor pattern may include amorphous silicon, low temperature polycrystalline silicon, or polycrystalline silicon.

The second insulating layer 20 may commonly overlap the pixels and may cover the semiconductor pattern SP. The second insulating layer 20 may be an inorganic layer and/or an organic layer and may have a single-layer or multi-layer structure. The second insulating layer 20 may include at least one of aluminium oxide, titanium oxide, silicon oxide, silicon nitride, silicon oxynitride, zirconium oxide, and hafnium oxide. In the embodiment, the second insulating layer 20 may have a single-layer structure of a silicon oxide layer.

The semiconductor pattern SP may include a source area SR, a drain area DR, and a channel area CR (or an active) distinguished from each other depending on a degree of conductivity. The channel area CR may overlap the gate electrode GE when viewed in a plane. The source area SR and the drain area DR may be spaced apart from each other with the channel area CR interposed therebetween. In the case that the semiconductor pattern SP is the oxide semiconductor, each of the source area SR and the drain area DR may be a reduced area. Accordingly, the source area SR and the drain area DR may have a relatively high content of reduced metal compared with the channel area CR. According to an embodiment, in the case that the semiconductor pattern SP is the polycrystalline silicon, each of the source area SR and the drain area DR may be a highly doped area.

The source area SR and the drain area DR may have a relatively high conductivity compared with the channel area CR. The source area SR may correspond to a source electrode of the connection transistor TR, and the drain area DR may correspond to a drain electrode of the connection transistor TR.

As shown in FIG. 6A, the connection transistor TR may further include a separate source electrode pattern W1 and a separate drain electrode pattern W2, which are respectively connected to source area SR and the drain area DR. The source electrode pattern W1 and the source area SR of the semiconductor pattern SP may serve as the source of the connection transistor TR. The drain electrode pattern W2 and the drain area DR of the semiconductor pattern SP may serve as the drain of the connection transistor TR. The source electrode pattern W1 and the drain electrode pattern W2 may be integral with at least one of lines forming the pixel driver PC, however, it should not be limited thereto or thereby.

The gate electrode GE may be disposed on the second insulating layer 20. The gate electrode GE may correspond to the gate of the connection transistor TR. The gate electrode GE may be disposed on the semiconductor pattern SP, however, this is merely an example. According to an embodiment, the gate electrode GE may be disposed under the semiconductor pattern SP, and it should not be particularly limited.

The gate electrode GE may include, e.g., at least one of titanium (Ti), silver (Ag), molybdenum (Mo), aluminium (Al), aluminium nitride (AlN), tungsten (W), tungsten nitride (WN), copper (Cu), and an alloy thereof, however, it should not be particularly limited.

Among conductive patterns W1, W2, CPE1, CPE2, and CPE3, a first capacitor electrode CPE1 and a second capacitor electrode CPE2 may form the first capacitor C1. The first capacitor electrode CPE1 and the second capacitor electrode CPE2 may be spaced apart from each other with the first insulating layer 10 and the second insulating layer 20 interposed therebetween.

According to an embodiment, the first capacitor electrode CPE1 and the bottom conductive layer BML may be integral with each other. The second capacitor electrode CPE2 may be integral with the gate electrode GE.

A third capacitor electrode CPE3 may be disposed on the third insulating layer 30. The third capacitor electrode CPE3 may be spaced apart from the second capacitor electrode CPE2 with the third insulating layer 30 interposed therebetween and may overlap the second capacitor electrode CPE2. The third capacitor electrode CPE3 and the second capacitor electrode CPE2 may form the second capacitor C2.

The fourth insulating layer 40 may be disposed on the third capacitor electrode CPE3.

The source electrode pattern W1 and the drain electrode pattern W2 may be disposed on the fourth insulating layer 40. In the embodiment, the source electrode pattern W1 may be connected to the source area SR of the semiconductor pattern SP via a first contact hole CNT1. The drain electrode pattern W2 may be connected to the drain area DR of the semiconductor pattern SP via a second contact hole CNT2.

The fifth insulating layer 50 and the sixth insulating layer 60 may be disposed on the source electrode pattern W1 and the drain electrode pattern W2. The sixth insulating layer 60 may correspond to the insulating layer 60 described with reference to FIG. 5.

Each of the fifth insulating layer 50 and the sixth insulating layer 60 may be an organic layer. As an example, each of the fifth insulating layer 50 and the sixth insulating layer 60 may include benzocyclobutene (BCB), hexamethyldisiloxane (HMDSO), a general-purpose polymer such as polystyrene (PS), a polymer derivative having a phenolic group, an acrylic-based polymer such as polymethylmethacrylate (PMMA), an imide-based polymer such as polyimide, an aryl ether-based polymer, an amide-based polymer, a fluorine-based polymer, a p-xylene-based polymer, a vinyl alcohol-based polymer, or blends thereof.

The connection wiring CN may be disposed between the fifth insulating layer 50 and the sixth insulating layer 60. The connection wiring CN may include the driver connection part DCP, the emission connection part ECP, and the connection part CNP. FIG. 6A illustrates the driver connection part DCP and the emission connection part ECP, and a portion of the connection part CNP may be omitted for the convenience of explanation.

The driver connection part DCP may include a portion of the connection wiring CN, which is connected to the pixel driver PC. The driver connection part DCP may include the portion that is substantially connected to the connection transistor TR. In the embodiment, the driver connection part DCP may be connected to the drain electrode pattern W2 after penetrating through the fifth insulating layer 50 and may be connected to the drain area DR of the semiconductor pattern SP via the drain electrode pattern W2.

The emission connection part ECP may include a portion of the connection wiring CN, which is connected to the light emitting device LD. The emission connection part ECP may be exposed via the first opening OP1 defined through the sixth insulating layer 60 and may include the portion that is directly connected to the second electrode EL2. The connection structure of the second electrode EL2 in the emission connection part ECP will be described in detail below.

A pixel definition layer PDL and the light emitting device LD may be disposed on the sixth insulating layer 60.

The pixel definition layer PDL may be an organic layer. As an example, the pixel definition layer PDL may include benzocyclobutene (BCB), hexamethyldisiloxane (HMDSO), a general-purpose polymer such as polystyrene (PS), a polymer derivative having a phenolic group, an acrylic-based polymer such as polymethylmethacrylate (PMMA), an imide-based polymer such as polyimide, an aryl ether-based polymer, an amide-based polymer, a fluorine-based polymer, a p-xylene-based polymer, a vinyl alcohol-based polymer, or blends thereof.

In an embodiment, the pixel definition layer PDL may have a light absorbing property. For example, the pixel definition layer PDL may have a black color. The pixel definition layer PDL may include a black coloring agent. The black coloring agent may include a black dye or a black pigment. The black coloring agent may include carbon black, a metal material such as chromium, or an oxide thereof. The pixel definition layer PDL may correspond to a light blocking pattern having a light blocking property.

The pixel definition layer PDL may be provided with the light emitting opening OP-PDL (e.g., a third opening in claims) defined therethrough. The light emitting opening OP-PDL may be provided in plural, and the light emitting openings OP-PDL may respectively correspond to the light emitting devices LD. All components of the light emitting device LD may overlap the light emitting opening OP-PDL, and the light emitting opening OP-PDL may correspond to an area where the image corresponding to the light emitted from the light emitting device LD is substantially displayed. Accordingly, the shape of the light emitting part EP (see FIG. 3A) may substantially correspond to the shape of the light emitting opening OP-PDL when viewed in a plane.

In the embodiment, the first opening OP1 may be defined through the sixth insulating layer 60 to expose a portion of the connection wiring CN, and a second opening OP2 (e.g., a fourth opening in claims) may be defined through the pixel definition layer PDL to correspond to the first opening OP1 and to be spaced apart from the light emitting opening OP-PDL. As the portion of the connection wiring CN is exposed through the first opening OP1, the portion where the light emitting device LD is connected to the connection wiring CN may be provided.

According to an embodiment, the conductive patterns may further include a capping pattern CPP. The capping pattern CPP may be disposed to cover the connection wiring CN exposed without being covered by the sixth insulating layer 60 and the sixth insulating layer 60 exposed without being covered by the pixel definition layer PDL. An end portion of the capping pattern CPP may be covered by the pixel definition layer PDL.

The light emitting device LD may include an organic light emitting material, an inorganic light emitting material, an organic-inorganic light emitting material, a quantum dot, a quantum rod, a micro-LED, or a nano-LED.

The light emitting device LD may include the first electrode EL1, an intermediate layer ML, and the second electrode EL2. The first electrode EL1 may be a semi-transmissive electrode, a transmissive electrode, or a reflective electrode. According to an embodiment, the first electrode EL1 may include a reflective layer formed of, e.g., silver (Ag), magnesium (Mg), aluminium (Al), platinum (Pt), palladium (Pd), gold (Au), nickel (Ni), neodymium (Nd), iridium (Ir), chromium (Cr), or compounds thereof and a transparent or semi-transparent electrode layer formed on the reflective layer. The transparent or semi-transparent electrode layer may include, e.g., at least one selected from the group consisting of indium tin oxide (ITO), indium zinc oxide (IZO), indium gallium zinc oxide (IGZO), zinc oxide (ZnO), indium oxide (In₂O₃), and aluminium-doped zinc oxide (AZO). For instance, the first electrode EL1 may have a stack structure of ITO/Ag/ITO.

In the embodiment, the first electrode EL1 may be the anode of the light emitting device LD. For example, the first electrode EL1 may be connected to the first driving voltage line VDL (see FIG. 2A) and may receive the first power voltage VDD (see FIG. 2A). The first electrode EL1 may be connected to the first driving voltage line VDL (see FIG. 2A) in the display area DA (see FIG. 3A) or may be connected to the first power line PL1 (see FIG. 2A) in the peripheral area NDA (see FIG. 3A). In the case that the first electrode EL1 is connected to the first power line PL1 (see FIG. 2A) in the peripheral area NDA (see FIG. 3A), the first power line PL1 (see FIG. 2A) may be disposed in the peripheral area NDA, and the first electrode EL1 may extend to the peripheral area NDA (see FIG. 3A).

In the embodiment, the first electrode EL1 may overlap the light emitting opening OP-PDL and may not overlap the separator SPR, however, it should not be limited thereto or thereby. As described above, the first electrodes EL1 of each pixel may be integral with each other and may have a mesh shape in which openings OP-EL1 are defined in some areas as shown in FIG. 4C. For example, the first electrode EL1 may have a variety of shapes as long as the light emitting devices LD receive a same first power voltage VDD through their first electrodes EL1, and it should not be limited thereto or thereby.

The intermediate layer ML may be disposed between the first electrode EL1 and the second electrode EL2. In the embodiment, the intermediate layer ML may include at least one light emitting layer EML. The intermediate layer ML may include the light emitting layer EML and a functional layer FNL, however, this is merely an example. As an example, the functional layer FNL may include multiple layers or may include two or more layers spaced apart from each other with the light emitting layer EML interposed therebetween. According to an embodiment, the functional layer FNL may be omitted.

The light emitting layer EML may absorb an energy corresponding to a difference in electric potential between the first electrode EL1 and the second electrode EL2 and may emit the light. The light emitting layer EML may include an organic light emitting material, however, it should not be limited thereto or thereby. According to an embodiment, the light emitting layer EML may include an inorganic light emitting material or may include a layer obtained by mixing the organic light emitting material with the inorganic light emitting material.

The light emitting layer EML may be disposed to overlap the light emitting opening OP-PDL. In the embodiment, the light emitting layer EML may be formed separately in each of the pixels. In the case that the light emitting layer EML is formed separately in each of the light emitting parts EP (see FIG. 3A), the light emitting layer EML may emit light having at least one of blue, red, and green colors, however, it should not be limited thereto or thereby. According to an embodiment, the light emitting layer EML may have an integral shape to be commonly disposed in the light emitting parts EP (see FIG. 3A) adjacent to each other. The light emitting layer EML may provide blue light or white light.

The functional layer FNL may be disposed on the light emitting layer EML, however, this is merely an example. According to an embodiment, the functional layer FNL may be disposed between the light emitting layer EML and the first electrode EL1. According to an embodiment, the functional layer FNL may be provided in plural, and the functional layers FNL may be disposed between the light emitting layer EML and the first electrode EL1 and between the light emitting layer EML and the second electrode EL2.

The functional layer FNL may control a movement of electric charges. The functional layer FNL may include a hole injection/transport material and/or an electron injection/transport material. The functional layer FNL may include at least one of an electron block layer, a hole transport layer, a hole injection layer, a hole block layer, an electron transport layer, an electron injection layer, and an electric charge generating layer. FIG. 6A illustrates the electron transport layer disposed between the light emitting layer EML and the second electrode EL2 as a representative example of the functional layer FNL, however, the disclosure should not be limited thereto or thereby. The functional layer FNL should not be particularly limited as long as the function layer FNL is disposed between the first electrode EL1 and the light emitting layer EML or between the second electrode EL2 and the light emitting layer EML and may control the movement of the electrons.

The second electrode EL2 may be disposed on the intermediate layer ML. As described above, the second electrode EL2 may be connected to the pixel driver PC via the fourth node N4 of FIG. 2A or the second node N2 of FIG. 2B. In the embodiment, the second electrode EL2 may be electrically connected to the connection transistor TR via the connection wiring CN.

In the embodiment, the display panel DP may include the separator SPR. The separator SPR may be disposed on the pixel definition layer PDL. The second electrode EL2 and the intermediate layer ML may be commonly formed in the light emitting parts by using an open mask. The second electrode EL2 and the intermediate layer ML may be separated by the separator SPR. As described above, the separator SPR may have a closed-line shape with respect to each light emitting part EP (see FIG. 3A) to be independent for each light emitting part EP (see FIG. 3A), and thus, the second electrode EL2 may have a shape divided for each of the light emitting parts EP1, EP2, and EP3 (see FIG. 4A). For example, the second electrode EL2 may be electrically independent of the second electrode EL2 of each neighboring pixel.

Separation patterns UP1 and UP2 may be disposed on the separator SPR. The separation patterns UP1 and UP2 may include a first separation pattern UP1 and a second separation pattern UP2.

The first separation pattern UP1 and the intermediate layer ML may include a same material. For example, the first separation pattern UP1 may correspond to a residue separated from the intermediate layer ML by the separator SPR in the case that the intermediate layer ML is commonly formed.

The second separation pattern UP2 and the second electrode EL2 may include a same material. For example, the second separation pattern UP2 may correspond to a residue separated from the second electrode EL2 by the separator SPR in the case that the second electrode EL2 is commonly formed.

Hereinafter, the connection wiring CN will be described in detail with reference to FIGS. 6A to 6C.

The connection wiring CN may have a three-layer structure. In detail, the connection wiring CN may include a first layer L1, a second layer L2 disposed under the first layer L1, and a third layer L3 disposed under the second layer L2. For example, the third layer L3, the second layer L2, and the first layer L1 may be sequentially stacked on each other.

The first layer L1 may have a relatively small thickness compared with the second layer L2. The first layer L1 may include a material with a lower etch rate compared with the second layer L2. As an example, the first layer L1 may include titanium (Ti).

The second layer L2 and the first layer L1 may include different materials. The second layer L2 may include a material with a high conductivity. As an example, the second layer L2 may include aluminium (Al).

The third layer L3 and the second layer L2 may include different materials. The third layer L3 may include a material with a lower etch rate compared with the second layer L2. As an example, the third layer L3 may include titanium (Ti).

In the embodiment, the line opening OP-CN (e.g., a second opening in claims) may be defined through the connection wiring CN, and the inner side surface IS of the connection wiring CN, which defines the line opening OP-CN, may include the opening portions OA and the cover portions CA. FIGS. 6A to 6C illustrate a cross-section of an opening portion OA and a cross-section of a cover portion CA.

The inner side surface IS (see FIG. 5) of the emission connection part ECP, which defines the line opening OP-CN, may include an inner side surface IS_L1 of the first layer L1, an inner side surface IS_L2 of the second layer L2, and an inner side surface IS_L3 of the third layer L3. Accordingly, the opening portion OA may include a portion of the inner side surface IS_L1 of the first layer L1, a portion of the inner side surface IS_L2 of the second layer L2, and a portion of the inner side surface IS_L3 of the third layer L3, and the cover portion CA may include the other portion of the inner side surface IS_L1 of the first layer L1, the other portion of the inner side surface IS_L2 of the second layer L2, and the other portion inner side surface IS_L3 of the third layer L3.

A tip part TP may be formed in the opening portion OA. In the opening portion OA, the inner side surface IS_L2 of the second layer L2 may be placed inside or inward the inner side surface IS_L1 of the first layer L1. In other words, the inner side surface IS_L1 of the first layer L1 may protrude outward from the inner side surface IS_L2 of the second layer L2 in the opening portion OA. When viewed in a cross-section, the inner side surface IS_L1 of the first layer L1 in the opening portion OA may be closer to a center of the line opening OP-CN than the inner side surface IS_L2 of the second layer L2 in the opening portion OA. For example, the inner side surface IS_L2 of the second layer L2 may be placed inside or inward the inner side surface IS_L1 of the first layer L1 and may have an undercut shape or an overhang structure in the opening portion OA. A portion of the first layer L1, which protrudes outward the second layer L2, may become the tip part TP.

In the opening portion OA, the inner side surface IS_L2 of the second layer L2 may be placed inside or inward the inner side surface IS_L3 of the third layer L3, and the inner side surface IS_L3 of the third layer L3 may protrude outward from the inner side surface IS_L2 of the second layer L2.

A portion of the connection wiring CN may be exposed without being covered by the sixth insulating layer 60 and the pixel definition layer PDL. In detail, the opening portions OA and the portion of the connection wiring CN adjacent to the opening portions OA, e.g., a portion of an upper surface of the first layer L1, may be exposed via the first opening OP1 defined through the sixth insulating layer 60 and the second opening OP2 defined through the pixel definition layer PDL without being covered by the sixth insulating layer 60 and the pixel definition layer PDL.

The tip part TP may not be formed in the cover portion CA. For example, the inner side surface IS_L1 of the first layer L1, the inner side surface IS_L2 of the second layer L2, and the inner side surface IS_L3 of the third layer L3 may be aligned with each other in the cover portion CA.

The cover portion CA may be covered by the sixth insulating layer 60. In the cover portion CA, each of the inner side surface IS_L1 of the first layer L1, the inner side surface IS_L2 of the second layer L2, and the inner side surface IS_L3 of the third layer L3 may contact the sixth insulating layer 60 and may be covered by the sixth insulating layer 60. Accordingly, the cover portion CA may not be exposed and may be covered by the sixth insulating layer 60 and the pixel definition layer PDL.

The capping pattern CPP may cover the portion of the connection wiring CN, which are exposed through the first opening OP1, and a portion of the fifth insulating layer 50. The capping pattern CPP may cover a portion of the sixth insulating layer 60, which is exposed through the second opening OP2. An end portion of the capping pattern CPP may be covered by the pixel definition layer PDL.

As the capping pattern CPP covers the connection wiring CN, a metal material included in the connection wiring CN, e.g., a metal material of the second layer L2, may be prevented from being dissolved in an etchant in a process of patterning the first electrode EL1 that is performed after a process of forming the first opening OP1 and a process of forming the tip part TP of the connection wiring CN. Accordingly, as the display panel DP includes the capping pattern CPP, the metal material included in the first electrode EL1 may be prevented from being precipitated by the metal material included in the connection wiring CN.

The capping pattern CPP may include an end CPN1 formed along an upper surface of the fifth insulating layer 50 and another end CPN2 formed on an upper surface of the first layer L1 in which the tip part TP is formed. For example, the capping pattern CPP may be disconnected in a portion disposed on the connection wiring CN exposed without being covered by the sixth insulating layer 60. The end CPN1 of the capping pattern CPP may contact the exposed inner side surface IS_L2 of the second layer L2, and the another end CPN2 may contact an end of the first layer L1. The capping pattern CPP may include the portion disconnected by the tip part TP, however, the capping pattern CPP may have an integral shape as a whole.

The second electrode EL2 may include a portion disposed inside the first opening OP1 and the second opening OP2. In the embodiment, the portion of the second electrode EL2 may be disposed on the capping pattern CPP exposed without being covered by the pixel definition layer PDL. The second electrode EL2 may include an end EN1 formed adjacent to the exposed inner side surface IS_L2 of the second layer L2 and another end EN2 formed adjacent to the upper surface of the first layer L1 in which the tip part TP is formed. For example, the second electrode EL2 may be disconnected in a portion disposed on the connection wiring CN exposed without being covered by the sixth insulating layer 60. As the end EN1 of the second electrode EL2 may contact the capping pattern CPP that is connected to the exposed inner side surface IS_L2 of the second layer L2, the second electrode EL2 may be connected to the connection wiring CN through the capping pattern CPP corresponding to the conductive pattern.

The intermediate layer ML may be placed inside the first opening OP1 and the second opening OP2 and may be separated into two portions around the tip part TP. In the embodiment, the intermediate layer ML may contact the capping pattern CPP exposed without being covered by the pixel definition layer PDL. The intermediate layer ML may include an end MN1 formed adjacent to the exposed inner side surface IS_L2 of the second layer L2 and another end MN2 formed adjacent to the upper surface of the first layer L1 in which the tip part TP is formed. For example, the intermediate layer ML may be disconnected in a portion disposed on the connection wiring CN exposed without being covered by the sixth insulating layer 60.

Each of the second electrode EL2 and the intermediate layer ML may include the portion disconnected by the tip part TP, however, each of the second electrode EL2 and the intermediate layer ML may have an integral shape as a whole.

In the embodiment, due to a difference in deposition angle between a deposition material for the second electrode EL2 and a deposition material for the intermediate layer ML, the second electrode EL2 may contact a portion of the capping pattern CPP that contacts the exposed inner side surface IS_L2 of the second layer L2 and is exposed without being covered by the intermediate layer ML.

According to an embodiment, the capping pattern CPP may be omitted. The intermediate layer ML may contact the portion of the connection wiring CN and the portion of the upper surface of the fifth insulating layer 50, which are exposed through the first opening OP1, and the portion of the sixth insulating layer 60 exposed through the second opening OP2. The second electrode EL2 may directly contact the portion of the exposed inner side surface IS_L2 of the second layer L2, which is exposed without being covered by the intermediate layer ML, and may be connected to the emission connection part ECP.

According to the embodiment, as the display panel DP includes the connection wiring CN, the second electrode EL2 may be readily electrically connected to the connection transistor TR. According to the disclosure, as the tip part TP is formed in the connection wiring CN, the connection wiring CN or the capping pattern CPP may be partially exposed without a separate patterning process for the intermediate layer ML. Further, the second electrode EL2 may contact the connection wiring CN or the capping pattern CPP exposed by adjusting the deposition angle. Accordingly, even though the second electrode EL2 connected to the pixel driver PC is formed after the first electrode EL1 is formed, the display panel DP in which the second electrode EL2 is connected to the pixel driver PC may be readily implemented.

FIG. 7 is a schematic enlarged plan view of an emission connection part ECP and a connection part CNP adjacent to the emission connection part ECP of a connection wiring CN, and a portion of the connection wiring CN of FIG. 7 may correspond to the portion of the connection wiring CN of FIG. 5. FIG. 7 illustrates a relationship between the connection wiring CN and each of a sixth insulating layer 60, a pixel definition layer PDL, and a capping pattern CPP.

Referring to FIG. 7, opening portions OA may be alternately arranged with cover portions CA. Each of the opening portions OA may overlap a first opening OP1 and may be exposed through the sixth insulating layer 60, and a tip part may be formed in the opening portions OA. On the other hand, each of the cover portions CA may be covered by the sixth insulating layer 60, and the tip part may not be formed in the cover portions CA. Accordingly, the portions in which the tip part TP (see FIG. 6C) is formed may be alternately arranged with the portions in which the tip part is not formed.

A second opening OP2 may overlap the first opening OP1 when viewed in a plane. The second opening OP2 may have an area equal to or greater than an area of the first opening OP1 when viewed in a plane. According to an embodiment, the second opening OP2 may have a circular shape when viewed in a plane.

The capping pattern CPP may overlap an entirety of the second opening OP2. The capping pattern CPP may have an area greater than an area of the second opening OP2 when viewed in a plane. An end portion of the capping pattern CPP may be covered by the pixel definition layer PDL.

In the embodiment, the capping pattern CPP may have a circular shape when viewed in a plane. However, the shape of the capping pattern CPP in a plane may be changed depending on a shape of the first opening OP1 and a shape of an outer side surface OS of the emission connection part ECP.

According to the embodiment, a contact area of the second electrode EL2 (see FIG. 6A) may be secured via a line opening OP-CN defined through the emission connection part ECP. Accordingly, when compared with a comparative example in which a second electrode EL2 is connected via a single surface extending in a direction, in the embodiment in which the second electrode EL2 (see FIG. 6A) is connected via an inner side surface IS defining the line opening OP-CN with the closed-line shape in a plane, the area where the second electrode EL2 (see FIG. 6A) is connected to the emission connection part ECP may be increased in the first opening OP1 of a same area. Thus, a contact resistance of the second electrode EL2 (see FIG. 6A) may be reduced, and an occurrence of voltage drop in the second electrode EL2 (see FIG. 6A) may be reduced. Accordingly, an electrical reliability of the display panel DP (see FIG. 1) may be improved.

In the embodiment, the area of the first opening OP1 in a plane, which is required to secure the contact area of the second electrode EL2 (see FIG. 6A) to a certain level, may be reduced when compared with the comparative example. Accordingly, the area of the first opening OP1 in plane, the area of the capping pattern CPP in plane, and the area of the second opening OP2 in plane may be reduced, and an area in which the light emitting parts EP (see FIG. 3A) are arranged may be increased. Thus, the display panel DP (see FIG. 1) may have a high resolution.

According to the embodiment, as the cover portions CA with a reverse curvature with respect to the opening portions OA are provided, the contact area of the second electrode EL2 (see FIG. 6A) may be compensated for by the cover portions CA even though a position of the first opening OP1 is slightly different from a position (e.g., a predetermined or selectable position) due to a process error in the process of forming the first opening OP1. The tip part TP (see FIG. 6C) may be formed in the portion of the cover portions CA exposed without being covered by the sixth insulating layer 60 due to the process error.

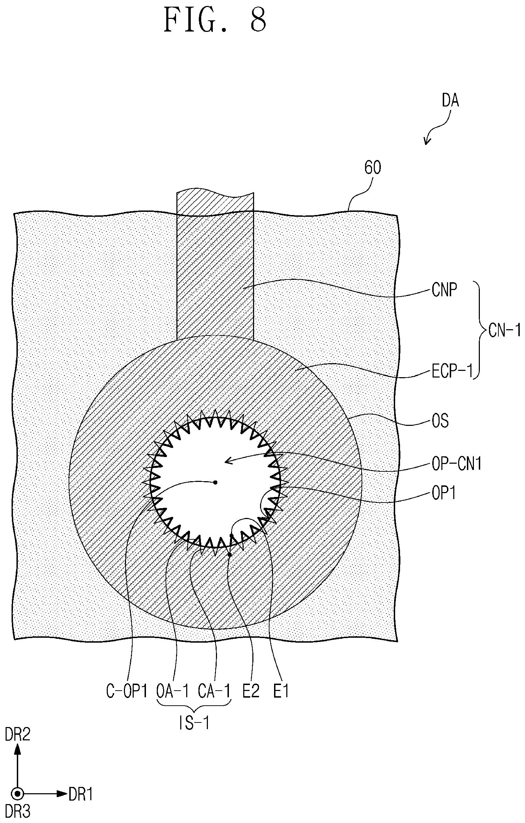

FIG. 8 is a schematic enlarged plan view of a portion of a display area DA according to an embodiment of the disclosure. FIG. 8 illustrates a connection wiring CN-1 and a sixth insulating layer 60, and illustrates a schematic enlarged view of an emission connection part ECP-1 and a portion of a connection part CNP adjacent thereto of the connection wiring CN-1. In FIG. 8, the same/similar reference numerals and/or reference characters denote the same/similar elements in FIGS. 4A to 7, and detailed descriptions of the same/similar elements will be omitted.

Referring to FIG. 8, a line opening OP-CN1 may be defined through the emission connection part ECP-1. An inner side surface IS-1 of the connection wiring CN-1, which defines the line opening OP-CN1, may include opening portions OA-1 and cover portions CA-1, and the opening portions OA-1 may be alternately arranged with the cover portions CA-1 along an imaginary line provided in a circular shape.

In the embodiment, the opening portions OA-1 and the cover portions CA-1 may be defined only by straight lines when viewed in a plane. In detail, the opening portions OA-1 and the cover portions CA-1 may have a zigzag shape defined by the straight line when viewed in a plane.

As an example, each of the opening portions OA-1 and each of the cover portions CA-1 may have a V shape. A vertex E1 (or a center) in the V shape of the opening portions OA-1 may point in a direction toward a center C-OP1 of a first opening OP1. A vertex E2 (or a center) in the V shape of the cover portions CA-1 may point in a direction away from the center C-OP1 of the first opening OP1.

The opening portions OA-1 may overlap the first opening OP1 and may be exposed without being covered by the sixth insulating layer 60, and the cover portions CA-1 may be covered by the sixth insulating layer 60. In each of the opening portions OA-1, as a position thereof becomes closer to the vertex E1 (or a center of each of the opening portions OA-1) in the V shape, a distance from the position to the center C-OP1 of the first opening OP1 may decrease, and in each of the cover portions CA-1, as a position thereof becomes closer to the vertex E2 (or, a center of each of the cover portions CA-1) in the V shape, a distance from the position to the center C-OP1 of the first opening OP1 may increase.

A tip part TP (see FIG. 6C) may be formed in the opening portions OA-1, and the second electrode EL2 (see FIG. 6C) may be connected to the inner side surface IS-1 of the connection wiring CN-1 in the opening portions OA-1. As the tip part TP is not formed in the cover portions CA-1, a path through which the second electrode EL2 (see FIG. 6A) extends to the area overlapping light emitting parts EP1, EP2, and EP3 (see FIG. 4A), e.g., light emitting opening OP-PDL (see FIG. 6A) may be provided.

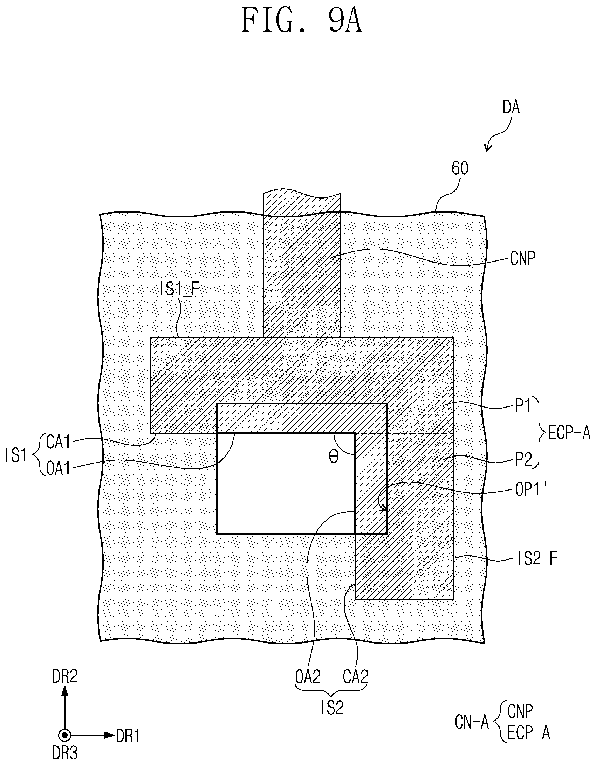

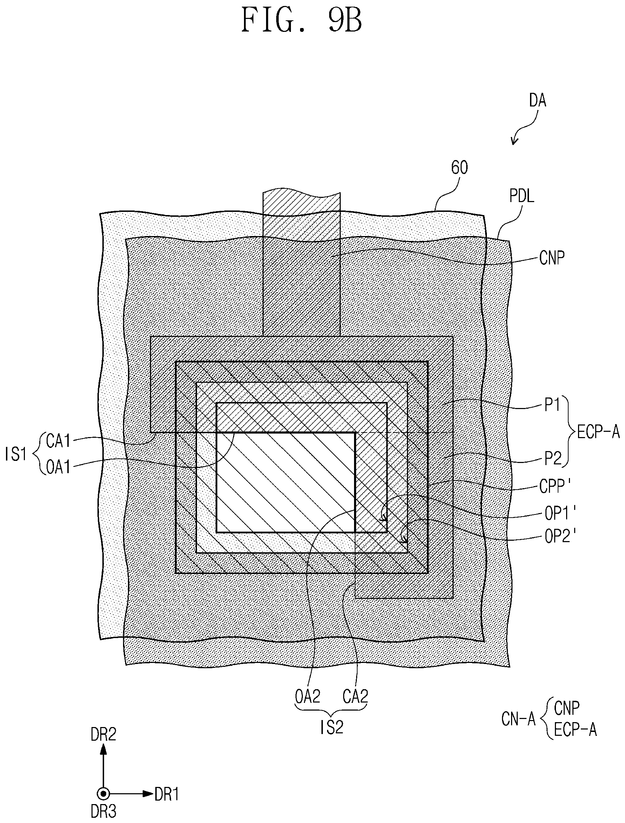

FIGS. 9A and 9B are schematic enlarged plan views of a portion of a display area DA according to an embodiment of the disclosure. FIGS. 9A and 9B illustrate enlarged views of an emission connection part ECP-A and a portion of a connection part CNP adjacent to the emission connection part ECP-A of a connection wiring CN-A. FIG. 9A illustrates the connection wiring CN-A and a sixth insulating layer 60, and FIG. 9B illustrates the connection wiring CN-A, the sixth insulating layer 60, a pixel definition layer PDL, and a capping pattern CPP' to explain an arrangement relationship between the connection wiring CN-A, the sixth insulating layer 60, the pixel definition layer PDL, and the capping pattern CPP' when viewed in a plane. In FIGS. 9A and 9B, the same/similar reference numerals and/or reference characters denote the same/similar elements in FIGS. 1 to 7, and thus, detailed descriptions of the same/similar elements will be omitted.

Referring to FIG. 9A, the emission connection part ECP-A may include a first portion P1 and a second portion P2. The first portion P1 may extend in a direction, and the second portion P2 may extend from an end portion of the first portion P1 in a first cross direction crossing (or intersecting) the direction. In FIG. 9A, the direction may correspond to the first direction DR1, and the first cross direction may correspond to the second direction DR2. An angle between the direction and the first cross direction should not be particularly limited. Hereinafter, the embodiment will be described based on the conditions that the direction corresponds to the first direction DR1, and the first cross direction corresponds to the second direction DR2.

Among side surfaces of the first portion P1 extending in the first direction DR1, a side surface adjacent to the second portion P2 will be referred to as a first side surface IS1. Among side surfaces of the second portion P2 extending in the second direction DR2, a side surface extending from an end of the first side surface IS1 will be referred to as a second side surface IS2. An angle θ between the first side surface IS1 and the second side surface IS2 may be smaller than about 180 degrees.

In the embodiment, the first side surface IS1 may include a first opening portion OA1 and a first cover portion CA1.

In the embodiment, the first opening portion OA1 may overlap a first opening OP1' defined through the sixth insulating layer 60 and may be exposed without being covered by the sixth insulating layer 60. The tip part TP (see FIG. 6C) may be formed in the first opening portion OA1. The first cover portion CA1 may be covered by the sixth insulating layer 60. The tip part TP may not be formed in the first cover portion CA1. The first opening portion OA1 may have a shape corresponding to the shape of the opening portion OA (see FIG. 6A) described with reference to FIGS. 6A to 6C in a cross-sectional view, and the first cover portion CA1 may have a shape corresponding to the shape of the cover portion CA (see FIG. 6A) described with reference to FIGS. 6A to 6C.

An end of the first opening portion OA1 may be connected to the second side surface IS2, and the first cover portion CA1 may extend from another end of the first opening portion OA1 spaced apart from the second side surface IS2. The first cover portion CA1 may be a remaining portion of the first side surface IS1 except the first opening portion OA1.

According to an embodiment, the first cover portion CA1 may be omitted, and the first side surface IS1 may include only the first opening portion OA1. The first side surface IS1 may be entirely exposed without being covered by the sixth insulating layer 60, and the tip part TP (see FIG. 6C) may be formed in the entirety of the first side surface IS1.

In the embodiment, the second side surface IS2 may include a second opening portion OA2 and a second cover portion CA2.

In the embodiment, the second opening portion OA2 may overlap the first opening OP1' defined through the sixth insulating layer 60 and may be exposed without being covered by the sixth insulating layer 60. The tip part TP (see FIG. 6C) may be formed in the second opening portion OA2. The second cover portion CA2 may be covered by the sixth insulating layer 60, and the tip part TP may not be formed in the second cover portion CA2. For example, the second opening portion OA2 may have a shape corresponding to the shape of the opening portion OA (see FIG. 6A) described with reference to FIGS. 6A to 6C in a cross-sectional view, and the second cover portion CA2 may have a shape corresponding to the shape of the cover portion CA (see FIG. 6A) described with reference to FIGS. 6A to 6C in a cross-sectional view.

An end of the second opening portion OA2 may be connected to the first opening portion OA1, and the second cover portion CA2 may extend from another end of the second opening portion OA2 spaced apart from the first opening portion OA1. The second cover portion CA2 may be a remaining portion of the second side surface IS2 except the second opening portion OA2.

According to an embodiment, the second cover portion CA2 may be omitted, and the second side surface IS2 may include only the second opening portion OA2. The second side surface IS2 may be entirely exposed without being covered by the sixth insulating layer 60, and the tip part TP (see FIG. 6C) may be formed in the entirety of the second side surface IS2.

According to the embodiment, as the tip part TP (see FIG. 6C) is formed in the first and second opening portions OA1 and OA2, the second electrode EL2 (see FIG. 6A) may be connected to at least a portion of the first side surface IS1 and at least a portion of the second side surface IS2 of the connection wiring CN-A. As the tip part TP is not formed in the first and second cover portions CA1 and CA2, a path through which the second electrode EL2 (see FIG. 6A) extends to the light emitting opening OP-PDL (see FIG. 6A) may be provided.

The other side surfaces of the first portion P1 except the first side surface IS1 and the other side surfaces of the second portion P2 except the second side surface IS2 may be covered by the sixth insulating layer 60.

In the embodiment, the connection part CNP may extend from a first opposite side surface IS1_F of the first portion P1, which is opposite to the first side surface IS1, however, it should not be limited thereto or thereby. According to an embodiment, the connection part CNP may extend from at least one of the side surfaces of the first portion P1 extending in the second direction DR2. According to an embodiment, the connection part CNP may extend from a second opposite side surface IS2_F of the second portion P2, which is opposite to the second side surface IS2, or the connection part CNP may extend from at least one of the side surfaces of the second portion P2 extending in the first direction DR1.

In the embodiment, the first opening OP1' may have a quadrangular shape when viewed in a plane. As an example, a boundary of the first opening OP1' may include sides extending in the first direction DR1 and sides extending in the second direction DR2.

Referring to FIG. 9B, a second opening OP2' defined through the pixel definition layer PDL may entirely overlap the first opening OP1'. The second opening OP2' may have an area equal to or greater than an area of the first opening OP1' when viewed in a plane. Accordingly, the first and the second opening portions OA1 and OA2 may be exposed via the second opening OP2' defined through the pixel definition layer PDL.

In the embodiment, the second opening OP2' may have a quadrangular shape when viewed in a plane. As an example, a boundary of the second opening OP2' may include sides extending in the first direction DR1 and sides extending in the second direction DR2.

The capping pattern CPP' may have an area greater than that of the second opening OP2' in a plane and may overlap the entirety of the second opening OP2'. An end portion of the capping pattern CPP' may be entirely covered by the pixel definition layer PDL.

In the embodiment, the capping pattern CPP' may have a quadrangular shape when viewed in a plane. As an example, a boundary of the capping pattern CPP' may include sides extending in the first direction DR1 and sides extending in the second direction DR2.

The shape of the first opening OP1' in a plane, the shape of the second opening OP2' in a plane, and the shape of the capping pattern CPP' in a plane should not be particularly limited as long as a portion to which the light emitting device is connected is provided.

According to the embodiment, the first opening portion OA1 extending in the first direction DR1 and the second opening portion OA2 extending from the first opening portion OA1 in the second direction DR2 may provide the side surface to which the second electrode EL2 (see FIG. 6A) is connected, and thus, the second electrode EL2 (see FIG. 6A) may be connected to the emission connection part ECP-A via two surfaces of the emission connection part ECP-A, which form a bent shape (or which extend in different directions), in a corresponding first opening OP1'. Accordingly, when compared with a comparative example in which the second electrode EL2 is connected via a single surface extending in a constant direction, in the embodiment in which the second electrode EL2 (see FIG. 6A) is connected via the two surfaces, the area where the second electrode EL2 (see FIG. 6A) is connected to the emission connection part ECP-A may be increased in the first opening OP1' of a same area. Therefore, a contact resistance of the second electrode EL2 (see FIG. 6A) may be reduced, and an occurrence of voltage drop in the second electrode EL2 (see FIG. 6A) may be reduced. Thus, an electrical reliability of the display panel DP (see FIG. 1) may be improved.

According to the embodiment, the area of the first opening OP1' in a plane, which is required to secure the contact area of the second electrode EL2 (see FIG. 6A) to a certain level, may be reduced when compared with the comparative example. Accordingly, the area of the first opening OP1' in a plane, the area of the capping pattern CPP' in a plane, and the area of the second opening OP2' in a plane may be reduced, and an area in which the light emitting parts EP (see FIG. 3A) are arranged may be increased. Thus, the high resolution of the display panel DP (see FIG. 1) may be readily implemented.

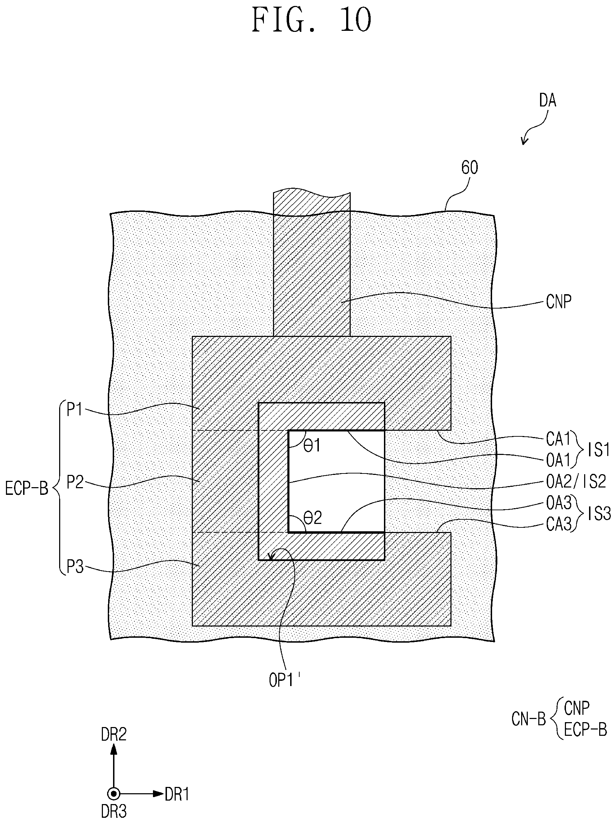

FIG. 10 is a schematic enlarged plan view of a portion of a display area DA according to an embodiment of the disclosure. FIG. 10 illustrates a connection wiring CN-B and a sixth insulating layer 60, and illustrates a schematic enlarged view of an emission connection part ECP-B and a portion of a connection part CNP adjacent thereto of the connection wiring CN-B. In FIG. 10, the same/similar reference numerals and/or reference characters denote the same/similar elements in FIGS. 1 to 9B, and thus, detailed descriptions of the same/similar elements will be omitted.

Referring to FIG. 10, the emission connection part ECP-B may include a first portion P1, a second portion P2, and a third portion P3.

The first portion P1 may extend in a direction, and the second portion P2 may extend from an end portion of the first portion P1 to a first cross direction crossing the direction. In the embodiment, the emission connection part ECP-B may further include the third portion P3, and the third portion P3 may extend from an end portion of the second portion P2 spaced apart from the first portion P1 to a second cross direction crossing the first cross direction. The third portion P3 may face the first portion P1.

FIG. 10 illustrates that each of the direction and the second cross direction corresponds to the first direction DR1, and the first cross direction corresponds to the second direction DR2, and an angle between the direction and the first and second cross directions should not be particularly limited. Hereinafter, the embodiment will be described based on the conditions that each of the direction and the second cross direction corresponds to the first direction DR1, and the first cross direction corresponds to the second direction DR2.

A side surface of the first portion P1 adjacent to the second portion P2 among two side surfaces extending in the first direction DR1 of the first portion P1 may be referred to as a first side surface IS1, and a side surface of the second portion P2 extending from an end of the first side surface IS1 among two side surfaces extending in the second direction DR2 of the second portion P2 may be referred to as a second side surface IS2. A side surface of the third portion P3 adjacent to the second portion P2, e.g., the side surface extending from the second side surface IS2, among two side surfaces of the third portion P3 extending in the first direction DR1 may be referred to as a third side surface IS3. Each of an angle θ1 between the first side surface IS1 and the second side surface IS2 and an angle θ2 between the second side surface IS2 and the third side surface IS3 may be smaller than about 180 degrees.

The first side surface IS1 may include a first opening portion OA1 and a first cover portion CA1, and details on the first opening portion OA1 and the first cover portion CA1 described with reference to FIG. 9A may be substantially equally applicable to the first opening portion OA1 and the first cover portion CA1 of FIG. 10.

In the embodiment, the second side surface IS2 may include only a second opening portion OA2. For example, the second side surface IS2 may entirely overlap a first opening OP1' and may be exposed without being covered by the sixth insulating layer 60. The tip part TP (see FIG. 6C) may be entirely formed in the second side surface IS2. The second side surface IS2 may have a shape corresponding to the shape of the opening portion OA shown in FIG. 6A in a cross-sectional view.

The third side surface IS3 may include a third opening portion OA3 and a third cover portion CA3.

In the embodiment, the third opening portion OA3 may overlap the first opening OP1' defined through the sixth insulating layer 60 and may be exposed without being covered by the sixth insulating layer 60. The tip part TP (see FIG. 6C) may be formed in the third opening portion OA3. The third cover portion CA3 may be covered by the sixth insulating layer 60. The tip part TP may not be formed in the third cover portion CA3. For example, the third opening portion OA3 may have a shape corresponding to the shape of the opening portion OA shown in FIG. 6A in a cross-sectional view, and the third cover portion CA3 may have a shape corresponding to the shape of the cover portion CA shown in FIG. 6A in a cross-sectional view.

An end of the third opening portion OA3 may be connected to the second opening portion OA2, and the third cover portion CA3 may extend from another end of the third opening portion OA3 spaced apart from the second opening portion OA2. The third opening portion OA3 may extend from the another end of the second opening portion OA2 spaced apart from the first opening portion OA1.

According to an embodiment, the third cover portion CA3 may be omitted, and the third side surface IS3 may include only the third opening portion OA3. The third side surface IS3 may be entirely exposed without being covered by the sixth insulating layer 60, and the tip part TP (see FIG. 6C) may be entirely formed in the third side surface IS3.

According to the embodiment, the second electrode EL2 (see FIG. 6A) may be connected to the emission connection part ECP-B through three surfaces having a bent shape of the emission connection part ECP-B in a corresponding first opening OP1'. Accordingly, the area where the second electrode EL2 (see FIG. 6A) is connected to the emission connection part ECP-B may be increased in the first opening OP1' having a certain area in a plane, and the electrical reliability of the display panel DP (see FIG. 1) may be improved.

According to the embodiment, the required contact area of the second electrode EL2 (see FIG. 6A) may be secured, and the area of the first opening OP1' in a plane, the area of the capping pattern CPP (see FIGS. 6A and 6B) in a plane, and the area of the second opening OP2 (see FIGS. 6A and 6B) in a plane may be reduced. Thus, the high resolution of the display panel DP (see FIG. 1) may be readily implemented.

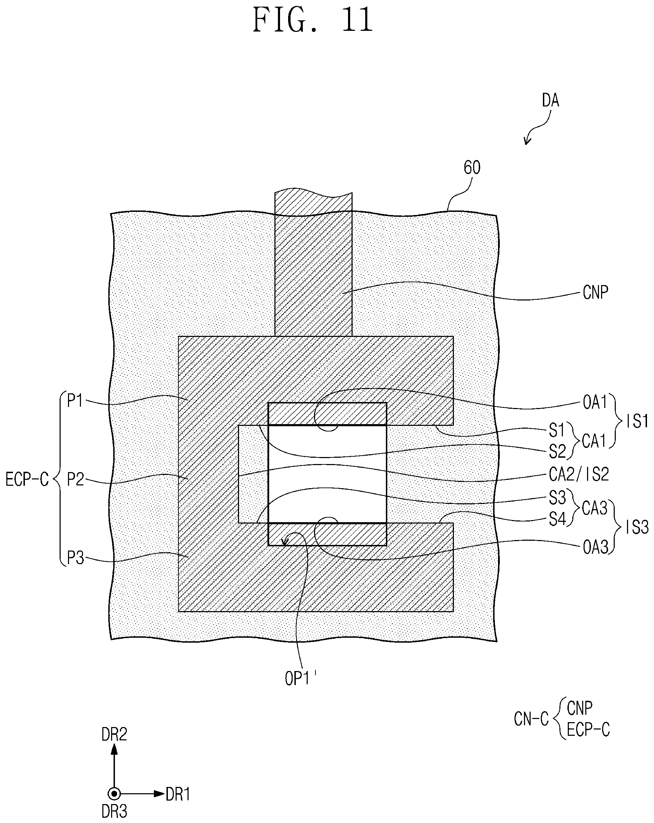

FIG. 11 is a schematic enlarged plan view of a portion of a display area DA according to an embodiment of the disclosure. FIG. 11 illustrates a connection wiring CN-C and a sixth insulating layer 60, and illustrates a schematic enlarged view of an emission connection part ECP-C and a portion of a connection part CNP adjacent to the emission connection part ECP-C of the connection wiring CN-C. In FIG. 11, the same/similar reference numerals and/or reference characters denote the same/similar elements in FIGS. 1 to 10, and thus, detailed descriptions of the same/similar elements will be omitted.

Referring to FIG. 11, the emission connection part ECP-C may include a first portion P1, a second portion P2, and a third portion P3. Details on the first, second, and third portions P1, P2, and P3 described with reference to FIG. 10 may be substantially equally applicable to the first, second, and third portions P1, P2, and P3 of FIG. 11.

A first side surface IS1 of the first portion P1 may include a first opening portion OA1 and a first cover portion CA1. The first opening portion OA1 may overlap a first opening OP1' defined through the sixth insulating layer 60 and may be exposed without being covered by the sixth insulating layer 60. The tip part TP (see FIG. 6C) may be formed in the first opening portion OA1. The first cover portion CA1 may be covered by the sixth insulating layer 60, and the tip part TP may not be formed in the first cover portion CA1.

In the embodiment, the first cover portion CA1 may include a first sub-portion S1 and a second sub-portion S2. The first sub-portion S1 and the second sub-portion S2 may be spaced apart from each other with the first opening portion OA1 interposed therebetween in the first direction DR1. The second sub-portion S2 may be disposed adjacent to a second side surface IS2 of the second portion P2.

In the embodiment, the second side surface IS2 of the second portion P2 may include only a second cover portion CA2. For example, the second side surface IS2 may be entirely covered by the sixth insulating layer 60, and the tip part TP may not be formed in the entire area of the second side surface IS2. The second cover portion CA2 may extend from an end of the second sub-portion S2 spaced apart from the first opening portion OA1.

A third side surface IS3 of the third portion P3 may include a third opening portion OA3 and a third cover portion CA3. The third opening portion OA3 may overlap the first opening OP1' defined through the sixth insulating layer 60 and may be exposed without being covered by the sixth insulating layer 60. The tip part TP (see FIG. 6C) may be formed in the third opening portion OA3. The third cover portion CA3 may be covered by the sixth insulating layer 60, and the tip part TP may not be formed in the third cover portion CA3.

In the embodiment, the third cover portion CA3 may include a third sub-portion S3 and a fourth sub-portion S4. The third sub-portion S3 and the fourth sub-portion S4 may be spaced apart from each other with the third opening portion OA3 interposed therebetween in the first direction DR1. The third sub-portion S3 may be disposed adjacent to the second side surface IS2 of the second portion P2.

The third opening portion OA3 may face the first opening portion OA1 in the second direction DR2. The third and fourth sub-portions S3 and S4 may face the second and first sub-portions S2 and S1 in the second direction DR2, respectively.

For example, according to the embodiment, the second electrode EL2 (see FIG. 6A) may be connected to the emission connection part ECP-C through two surfaces facing each other in a corresponding first opening OP1'. Accordingly, the area where the second electrode EL2 (see FIG. 6A) is connected to the emission connection part ECP-C may be increased in the first opening OP1' having a certain area in a plane, and the electrical reliability of the display panel DP (see FIG. 1) may be improved.

According to the embodiment, the required connection area of the second electrode EL2 (see FIG. 6A) may be secured, and the area of the first opening OP1' in a plane, the area of the capping pattern CPP' (see FIG. 9B) in a plane, and the area of the second opening OP2' (see FIG. 9B) in a plane may be reduced. Thus, the high resolution of the display panel DP (see FIG. 1) may be readily implemented.

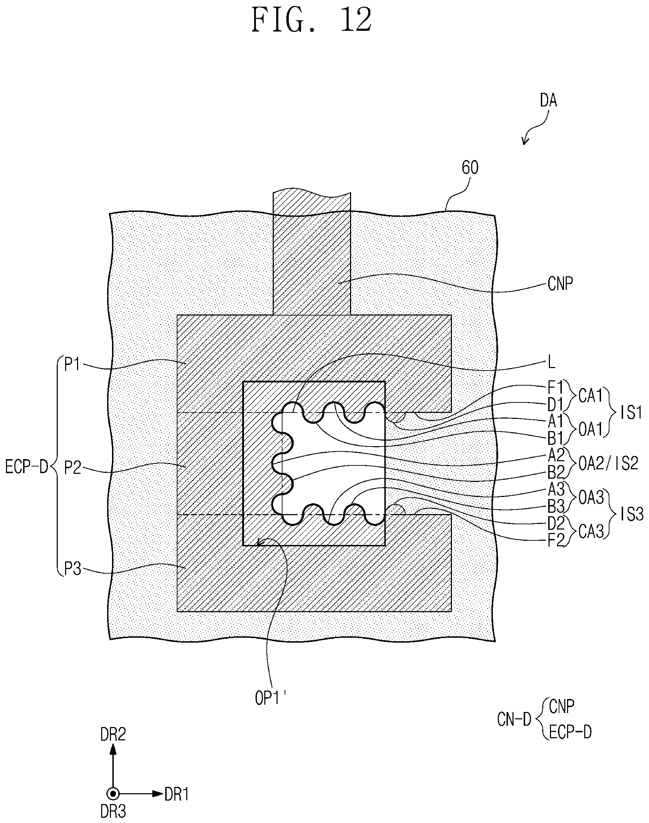

FIG. 12 is a schematic enlarged plan view of a portion of a display area DA according to an embodiment of the disclosure. FIG. 12 illustrates a connection wiring CN-D and a sixth insulating layer 60, and illustrates a schematic enlarged view of an emission connection part ECP-D and a portion of a connection part CNP adjacent to the emission connection part ECP-D of the connection wiring CN-D. In FIG. 12, the same/similar reference numerals and/or reference characters denote the same/similar elements in FIGS. 1 to 11, and thus, detailed descriptions of the same/similar elements will be omitted.

Referring to FIG. 12, the emission connection part ECP-D may include a first portion P1, a second portion P2, and a third portion P3. Details on the first, second, and third portions P1, P2, and P3 described with reference to FIG. 10 may be substantially equally applicable to the first, second, and third portions P1, P2, and P3 of FIG. 12.

A first side surface IS1 may extend in an extension direction of the first portion P1, e.g., the first direction DR1. A second side surface IS2 may extend in an extension direction of the second portion P2, e.g., the second direction DR2. A third side surface IS3 may extend in an extension direction of the third portion P3, e.g., the first direction DR1.

In the embodiment, the first side surface IS1 may include a first opening portion OA1 and a first cover portion CA1. Details on the first opening portion OA1 and the first cover portion CA1 described with reference to FIG. 10 may be similarly applied to the first opening portion OA1 and the first cover portion CA1 of FIG. 12.

The first opening portion OA1 may include first concave portions A1 and first convex portions B1. The first concave portions A1 may be alternately arranged with the first convex portions B1 in the first direction DR1.

In the embodiment, each of the first concave portions A1 and each of the first convex portions B1 may have a curvature. As an example, the first concave portions A1 and the first convex portions B1 may have a curved line shape when viewed in a plane. Each of the first concave portions A1 may have the curvature with a curvature center defined outside the emission connection part ECP-D. Each of the first convex portions B1 may have the curvature with a curvature center defined inside the emission connection part ECP-D. Accordingly, with respect to an imaginary straight line L extending in the first direction DR1, the first concave portions A1 may have a shape recessed from the imaginary straight line L, and the first convex portions B1 may have a shape protruding from the imaginary straight line L.

The first cover portion CA1 may include a first dummy portion D1 and a first flat portion F1.

The first dummy portion D1 may be disposed adjacent to the first opening portion OA1. The first dummy portion D1 may have a curvature corresponding to that of at least one of the first concave portion A1 and the first convex portion B1. As an example, in the case that the first concave portion A1 is disposed at an end portion of the first opening portion OA1 adjacent to the first cover portion CA1, the first dummy portion D1 may have a curvature corresponding to that of the first convex portion B1.

FIG. 12 illustrates that the first dummy portion D1 may have a constant curvature, however, the first dummy portion D1 may include a portion (hereinafter, referred to as a first dummy convex portion) having a curvature corresponding to that of the first convex portion B1 and a portion (hereinafter, referred to as a first dummy concave portion) having a curvature corresponding to that of the first concave portion A1. According to an embodiment, each of the first dummy convex portion and the first dummy concave portion may be provided in plural, and the first dummy convex portions may be alternately arranged with the first dummy concave portions. For example, the first dummy portion D1 may have a shape corresponding to a shape of a portion of the first opening portion OA1.

The first flat portion F1 may correspond to a portion of the first cover portion CA1 except the first dummy portion D1. The first flat portion F1 may not have a curvature and may have a flat surface extending in the first direction DR1.

According to an embodiment, the first flat portion F1 may be omitted, and the first cover portion CA1 may include only the first dummy portion D1. According to an embodiment, the first dummy portion D1 may be omitted, and the first cover portion CA1 may include only the first flat portion F1.

In the embodiment, the second side surface IS2 of the second portion P2 may include only a second opening portion OA2. Details on the second opening portion OA2 described with reference to FIG. 10 may be similarly applied to the second opening portion OA2 of FIG. 12.

The second opening portion OA2 may include second concave portions A2 and second convex portions B2. The second concave portions A2 may be alternately arranged with the second convex portions B2 in the second direction DR2.

Each of the second concave portions A2 and each of the second convex portions B2 may have a curvature. As an example, the second concave portions A2 and the second convex portions B2 may have a curved line shape when viewed in a plane. Each of the second concave portions A2 may have the curvature with a curvature center defined outside the emission connection part ECP-D. Each of the second convex portions B2 may have a curvature with the curvature center defined inside the emission connection part ECP-D.

In the embodiment, the third side surface IS3 of the third portion P3 may include a third opening portion OA3 and a third cover portion CA3. Details on the third opening portion OA3 and the third cover portion CA3 described with reference to FIG. 10 may be similarly applied to the third opening portion OA3 and the third cover portion CA3 of FIG. 12.

The third opening portion OA3 may include third concave portions A3 and third convex portions B3. The third concave portions A3 may be alternately arranged with the third convex portions B3 in the first direction DR1.

Each of the third concave portions A3 and each of the third convex portions B3 may have a curvature. As an example, the third concave portions A3 and the third convex portions B3 may have a curved line shape when viewed in a plane. Each of the third concave portions A3 may have the curvature with a curvature center defined outside the emission connection part ECP-D. Each of the third convex portions B3 may have the curvature with a curvature center defined inside the emission connection part ECP-D.

The third cover portion CA3 may include a second dummy portion D2 and a second flat portion F2.

The second dummy portion D2 may be disposed adjacent to the third opening portion OA3. The second dummy portion D2 may have a curvature corresponding to that of at least one of the third concave portion A3 and the third convex portion B3. As an example, in the case that the third concave portion A3 is disposed at an end portion of the third opening portion OA3 adjacent to the third cover portion CA3, the second dummy portion D2 may have a curvature corresponding to that of the third convex portion B3.

FIG. 12 illustrates that the second dummy portion D2 has a constant curvature, however, the second dummy portion D2 may include a portion (hereinafter, referred to as a second dummy convex portion) having a curvature corresponding to that of the third convex portion B3 and a portion (hereinafter, referred to as a second dummy concave portion) having a curvature corresponding to that of the third concave portion A3. According to an embodiment, each of the second dummy convex portion and the second dummy concave portion may be provided in plural, and the second dummy convex portions may be alternately arranged with the second dummy concave portions. For example, the second dummy portion D2 may have a shape corresponding to a shape of a portion of the third opening portion OA3.

The second flat portion F2 may correspond to a portion of the third cover portion CA3 except the second dummy portion D2. The second flat portion F2 may not have a curvature and may have a flat surface extending in the first direction DR1.

The second flat portion F2 may be omitted, and thus, the third cover portion CA3 may include only the second dummy portion D2. According to an embodiment, the second dummy portion D2 may be omitted, and thus, the third cover portion CA3 may include only the second flat portion F2.

According to the embodiment, as the first, second, and third concave portions A1, A2, and A3 and the first, second, and third convex portions B1, B2, and B3 are provided, the contact area of the second electrode EL2 (see FIG. 6A) may increase in a first opening OP1' of a same area when compared with a case in which a flat surface extending in a direction is provided. Accordingly, a voltage drop occurring in the second electrode EL2 (see FIG. 6A) may be further reduced.

According to the embodiment, as the first and second dummy portions D1 and D2 are provided, the contact area of the second electrode EL2 (see FIG. 6A) may be compensated for by the first and second dummy portions D1 and D2 even though a process error occurs in the process of forming the first opening OP1' and a position of the first opening OP1' is different from a position (e.g., a predetermined or selectable position), and e.g., the position of the first opening OP1' is shifted in the first direction DR1.

Similar to the emission connection part ECP-A described with reference to FIG. 9A, the emission connection part ECP-D may include only the first and second portions P1 and P2. The concave portions and the convex portions may be applied to the first and second opening portions OA1 and OA2, and the dummy portions and the flat portions may be applied to the first and second cover portions CA1 and CA2.

As described with reference to FIG. 11, the second side surface IS2 may include only the second cover portion CA2. The second cover portion CA2 may correspond to the flat portion including the flat surface extending in the second direction DR2, and the above-descriptions of the second concave portions A2 and the second convex portions B2 may not be applied.

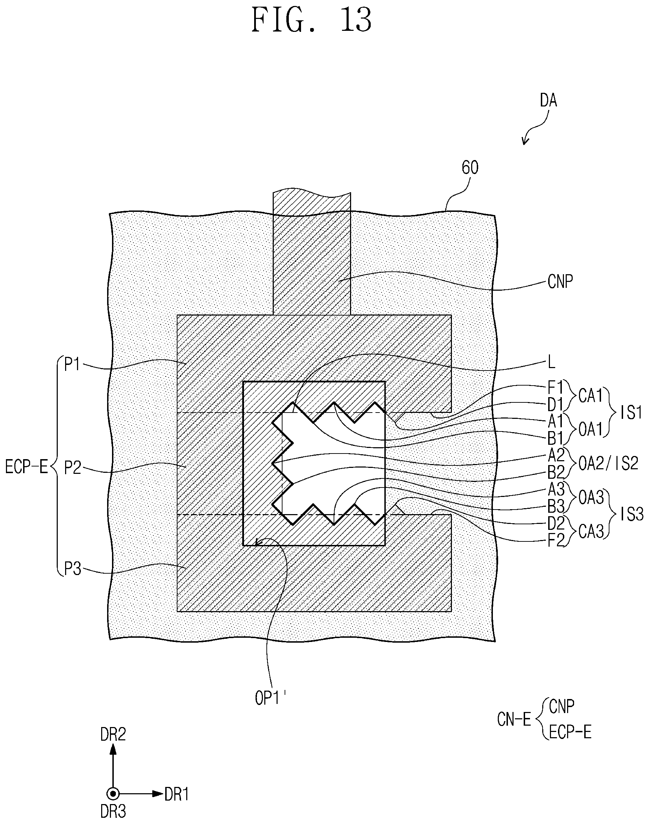

FIG. 13 is a schematic enlarged plan view of a portion of a display area DA according to an embodiment of the disclosure. FIG. 13 illustrates a connection wiring CN-E and a sixth insulating layer 60, and illustrates a schematic enlarged view of an emission connection part ECP-E and a portion of a connection part CNP adjacent to the emission connection part ECP-E of the connection wiring CN-E. In FIG. 13, the same/similar reference numerals and/or reference characters denote the same/similar elements in FIG. 12, and thus, detailed descriptions of the same/similar elements will be omitted.

Referring to FIG. 13, first, second, and third concave portions A1, A2, and A3 and first, second, and third convex portions B1, B2, and B3 may be defined by only straight lines when viewed in a plane. In detail, the first, second, and third concave portions A1, A2, and A3 and the first, second, and third convex portions B1, B2, and B3 may have a zigzag shape defined by the straight lines when viewed in a plane. As an example, each of the first, second, and third concave portions A1, A2, and A3 and each of the first, second, and third convex portions B1, B2, and B3 may have a V shape.

A vertex of the V shape of the first concave portion A1 and a vertex of the V shape of the first convex portion B1 may be disposed spaced apart from an imaginary straight line L, which extends in the first direction DR1, in directions opposite to each other. In other words, with respect to the imaginary straight line L extending in the first direction DR1, the first concave portions A1 may have a shape recessed from the imaginary straight line L, and the first convex portions B1 may have a shape protruding from the imaginary straight line L. Descriptions on the first concave portions A1 and the first convex portions B1 may be similarly applied to the second and third concave portions A2 and A3 and the second and third convex portions B2 and B3, respectively.

First and second dummy portions D1 and D2 may be defined by only straight lines when viewed in a plane. As an example, each of the first and second dummy portions D1 and D2 may have a V shape. The first dummy portion D1 may have the V shape corresponding to at least one of the first concave portion A1 and the first convex portion B1. According to an embodiment, the first dummy portion D1 may have a shape in which the V shape of the first concave portion A1 and the V shape of the first convex portion B1 are arranged. For example, the shape of the first dummy portion D1 may correspond to a shape of a portion of the first opening portion OA1. Descriptions on the first dummy portion D1 may be substantially equally applied to the second dummy portion D2.

According to the embodiment, as the first, second, and third concave portions A1, A2, and A3 and the first, second, and third convex portions B1, B2, and B3 are provided, the contact area of the second electrode EL2 (see FIG. 6A) may be increased, and a voltage drop occurring in the second electrode EL2 (see FIG. 6A) may be further reduced.

According to the embodiment, as the first and second dummy portions D1 and D2 are provided, the required connection area of the second electrode EL2 (see FIG. 6A) may be secured even though a process error occurs in the process of forming a first opening OP1'.

According to an embodiment, when viewed in a plane, some of the first, second, and third concave portions A1, A2, and A3 and the first, second, and third convex portions B1, B2, and B3 may be defined by the straight lines, and others of the first, second, and third concave portions A1, A2, and A3 and the first, second, and third convex portions B1, B2, and B3 may be defined by the curved lines. When viewed in a plane, at least one of the first and second dummy portions D1 and D2 may be defined by the straight line, and the other of the first and second dummy portions D1 and D2 may be defined by the curved line. According to an embodiment, when viewed in a plane, the first, second, and third concave portions A1, A2, and A3 and the first, second, and third convex portions B1, B2, and B3 may be defined by the straight lines, and the first and second dummy portions D1 and D2 may be defined by the curved lines, and vice versa.

The above description is an example of technical features of the disclosure, and those skilled in the art to which the disclosure pertains will be able to make various modifications and variations. Thus, the embodiments of the disclosure described above may be implemented separately or in combination with each other.

The embodiments disclosed in the disclosure are intended not to limit the disclosure but to describe the disclosure, and the scope of the disclosure is not limited by these embodiments. The protection scope of the disclosure should be interpreted by the following claims.

## Claims

1. A display panel (DP) comprising:
a transistor:
a light emitting device (LD) disposed on the transistor;
an insulating layer (60) disposed on the transistor and including a first opening (OP1); and
a connection wiring (CN) at least partially covered by the insulating layer (60) and electrically connecting the light emitting device (LD) and the transistor, the connection wiring (CN) comprising:
a first connection part (ECP) electrically connected to the light emitting device (LD) and including a second opening (OP-CN);
a second connection part (DCP) electrically connected to the transistor; and
a connection part (CNP) extending from the first connection part (ECP) to the second connection part (DCP),
wherein an inner side surface (IS) of the connection wiring (CN), which defines the second opening (OP-CN), comprises:
a first portion (OA) overlapping the first opening (OP1); and
a second portion (CA) covered by the insulating layer (60);
**characterized in that** the connection wiring (CN) comprises a first layer (L1) and a second layer (L2) disposed under the first layer (L1),
an inner side surface (IS_L1) of the first layer (L1) protrudes more than an inner side surface (IS_L2) of the second layer (L2) in the first portion (OA) to provide a tip part (TP), and
the inner side surface (IS_L1) of the first layer (L1) is aligned with the inner side surface (IS_L2) of the second layer (L2) in the second portion (CA).

2. The display panel (DP) of claim 1, wherein the first portion (OA) is disposed closer to a center (C-OP1) of the first opening (OP1) than the second portion (CA) is when viewed in a plane.

3. The display panel (DP) of claim 1 or claim 2, wherein
each of the first portion (OA) and the second portion (CA) has a curved line shape when viewed in a plane,
a curvature center (CC1) of the first portion (OA) is defined inside the first connection part (ECP), and
a curvature center (CC2) of the second portion (CA) is defined outside the first connection part (ECP).

4. The display panel (DP) of claim 1 or claim 2, wherein
each of the first portion (OA-1) and the second portion (CA-1) has a shape defined by straight lines when viewed in a plane,
the first portion (OA-1) has a vertex (E1) where the straight lines meet each other,
the vertex (E1) of the first portion (OA) is relatively closer to a center (C-OP1) of the first opening (OA-1) than the second portion (CA-1) is,
the second portion (CA-1) has a vertex (E2) where the straight lines meet each other, and
the vertex (E2) of the second portion (CA) is relatively farther away from the center (C-OP1) of the first opening (OP1) than the first portion (OA-1) is.

5. The display panel of any one of claims 1 to 4, wherein:
(i) the first portion (OA) includes a plurality of first portions (OA),
the second portion (CA) includes a plurality of second portions (CA), and
the plurality of first portions (OA) are alternately arranged with the plurality of second portions (CA); and/or
(ii) the first opening (OP1) has a circular shape when viewed in a plane.

6. The display panel (DP) of any one of claims 1 to 5, wherein
the light emitting device (LD) comprises:
a first electrode (EL1);
a second electrode (EL2) disposed on the first electrode (EL1); and
a light emitting layer (EML) disposed between the first and second electrodes (EL1, EL2), and
the second electrode (EL2) is electrically connected to the inner side surface (IS_L2) of the second layer (L2) in the first portion (OA), optionally wherein: the display panel (DP) further comprises:
a pixel definition layer (PDL) disposed on the insulating layer (60) and including:
a third opening (OP-PDL) exposing a portion of the first electrode (EL1); and
a fourth opening (OP-CN) overlapping the first opening (OP1); and
a separator (SPR) disposed on the pixel definition layer (PDL).

7. The display panel (DP) of any one of claims 1 to 6, further comprising:
a capping pattern (CPP) covering the connection wiring (CN) exposed through the first opening (OP1),
wherein the capping pattern (CPP) contacts the first portion (OA) and is spaced apart from the second portion (CA).

8. A display panel (DP) comprising:
a transistor:
a light emitting device (LD) disposed on the transistor;
an insulating layer (60) disposed on the transistor and including a first opening (OP1'); and
a connection wiring (CN-A, CN-B, CN-C) at least partially covered by the insulating layer (60) and electrically connecting the light emitting device (LD) and the transistor, the connection wiring (CN-A, CN-B, CN-C) comprising:
a first connection part (ECP-A, ECP-B, ECP-C) comprising a first portion (P1) extending in a direction and a second portion (P2) extending from the first portion (P1) to a first cross direction intersecting the direction and electrically connected to the light emitting device (LD);
a second connection part (DCP) electrically connected to the transistor; and
a connection part (CNP) extending from the first connection part (ECP-A, ECP-B, ECP-C) to the second connection part (DCP),
wherein at least one of a first side surface (IS1) of the first portion (P1) extending in the direction and a second side surface (IS2) of the second portion (P2) extending in the first cross direction overlaps the first opening (OP1');
**characterized in that** the connection wiring (CN-A, CN-B, CN-C, CN-D) comprises a first layer (L1) and a second layer (L2) disposed under the first layer (L1), and
a side surface (IS_L1) of the first layer (L1) protrudes more than a side surface (IS_L2) of the second layer (L2) in a portion of the first and second side surfaces (IS_L1, IS_L2), which overlaps the first opening to provide a tip part (TP),.

9. The display panel (DP) of claim 8, wherein an angle between the first side surface (IS1) and the second side surface (IS2) is smaller than about 180 degrees.

10. The display panel (DP) of claim 8 or claim 9, wherein
the connection wiring (CN-B) further comprises a third portion (P3) extending from the second portion (P2) to a second cross direction intersecting the first cross direction and facing the first portion (P1) in the first cross direction, and
at least a portion of the first side surface (IS1), the second side surface (IS2), and at least a portion of a third side surface (IS3) of the third portion (P3) extending in the second cross direction overlap the first opening (OP1').

11. The display panel (DP) of claim 8 or claim 9, wherein
the connection wiring (CN-C) further comprises a third portion (P3) extending from the second portion (P2) to a second cross direction intersecting the first cross direction and facing the first portion (P1) in the first cross direction,
at least a portion of the first side surface (IS1) and at least a portion of a third side surface (IS3) of the third portion (P3) extending in the second cross direction overlap the first opening (OP1'), and
the second side surface (IS2) does not overlap the first opening.

12. The display panel (DP) of claim 8 or claim 9, wherein
the first side surface (IS1) overlapping the first opening (OP1') comprises concave portions (A1-A3) and convex portions (B1-B3) alternately arranged with the concave portions (A1-A3),
each of the concave portions (A1-A3) has a curvature allowing a curvature center to be defined outside the first portion (P1), and
each of the convex portions (B1-B3) has a curvature allowing a curvature center to be defined inside the first portion (P1), optionally wherein:
the first side surface (IS1) further comprises a dummy portion (D1-D4) covered by the insulating layer (60), and
the dummy portion (D1-D3) has a shape corresponding to a shape of a portion of the concave portions (A1-A3) or the convex portions (B1-B3).

13. The display panel (DP) of claim 8 or claim 9, wherein
the first side surface (IS) overlapping the first opening (OP1') comprises concave portions (A1-A3) and convex portions (B1-B3) alternately arranged with the concave portions (A1-A3),
each of the concave portions (A1-A3) and each of the convex portions (B1-B3) are defined by straight lines when viewed in a plane, and
a center of each of the concave portions (A1-A3) and a center of each of the convex portions (B1-B3) are spaced apart from each other to directions opposite to each other with respect to an imaginary line (L) extending in the direction.

14. The display panel (DP) of any one of claims 8 to 13, wherein the light emitting device (LD) comprises:
a first electrode (EL1);
a second electrode (EL2) disposed on the first electrode (EL1); and
a light emitting layer (EML) disposed between the first and second electrodes (EL1, EL2), and
the second electrode (EL2) is electrically connected to the side surface (IS_L2) of the second layer (L2) in the portion of the first and second side surfaces (IS_L1, IS_L2), which overlaps the first opening (OP1'), more optionally wherein the display panel (DP) further comprises:
a pixel definition layer (PDL) disposed on the insulating layer (60) and including:
a light emitting opening (OP-PDL) exposing a portion of the first electrode (EL1); and
a second opening (OP2') overlapping the first opening (OP1'); and
a separator (SPR) disposed on the pixel definition layer (PDL).

## Patentansprüche

1. Anzeigefeld (DP), umfassend:
einen Transistor:
eine Leuchtdiode (LD), die auf dem Transistor angeordnet ist;
eine Isolierschicht (60), die auf dem Transistor angeordnet ist und eine erste Öffnung (OP1) beinhaltet; und
eine Verbindungsleitung (CN), die zumindest teilweise von der Isolierschicht (60) bedeckt ist und die lichtemittierende Vorrichtung (LD) und den Transistor elektrisch verbindet, wobei die Verbindungsleitung (CN) Folgendes umfasst:
ein erstes Verbindungsteil (ECP), das elektrisch mit der lichtemittierenden Vorrichtung (LD) verbunden ist und eine zweite Öffnung (OP-CN) beinhaltet;
ein zweites Verbindungsteil (DCP), das elektrisch mit dem Transistor verbunden ist; und
ein Verbindungsteil (CNP), das sich vom ersten Verbindungsteil (ECP) zum zweiten Verbindungsteil (DCP) erstreckt,
wobei eine innere Seitenfläche (IS) der Verbindungsleitung (CN), die die zweite Öffnung (OP-CN) definiert, Folgendes umfasst:
einen ersten Abschnitt (OA), der die erste Öffnung (OP1) überlappt; und
einen zweiten Abschnitt (CA), der von der Isolierschicht (60) bedeckt ist;
**dadurch gekennzeichnet, dass**
die Verbindungsleitung (CN) eine erste Schicht (L1) und eine zweite Schicht (L2), die unter der ersten Schicht (L1) angeordnet ist, umfasst,
eine innere Seitenfläche (IS_L1) der ersten Schicht (L1) mehr als eine innere Seitenfläche (IS_L2) der zweiten Schicht (L2) im ersten Abschnitt (OA) vorragt, um ein Spitzenteil (TP) bereitzustellen, und
die innere Seitenfläche (IS_L1) der ersten Schicht (L1) mit der inneren Seitenfläche (IS_L2) der zweiten Schicht (L2) im zweiten Abschnitt (CA) ausgerichtet ist.

2. Anzeigefeld (DP) nach Anspruch 1, wobei der erste Abschnitt (OA) bei Betrachtung in einer Ebene näher bei einem Mittelpunkt (C-OP1) der ersten Öffnung (OP1) angeordnet ist als der zweite Abschnitt (CA).

3. Anzeigefeld (DP) nach Anspruch 1 oder Anspruch 2, wobei
sowohl der erste Abschnitt (OA) als auch der zweite Abschnitt (CA) bei Betrachtung in einer Ebene eine gekrümmte Linienform aufweisen,
ein Krümmungsmittelpunkt (CC1) des ersten Abschnitts (OA) innerhalb des ersten Verbindungsteils (ECP) definiert ist und
ein Krümmungsmittelpunkt (CC2) des zweiten Abschnitts (CA) außerhalb des ersten Verbindungsteils (ECP) definiert ist.

4. Anzeigefeld (DP) nach Anspruch 1 oder Anspruch 2, wobei
sowohl der erste Abschnitt (OA-1) als auch der zweite Abschnitt (CA-1) bei Betrachtung in einer Ebene eine durch gerade Linien definierte Form aufweisen,
der erste Abschnitt (OA-1) einen Scheitelpunkt (E1) hat, an dem sich die geraden Linien treffen,
der Scheitelpunkt (E1) des ersten Abschnitts (OA) relativ näher bei einem Mittelpunkt (C-OP1) der ersten Öffnung (OA-1) liegt als der zweite Abschnitt (CA-1),
der zweite Abschnitt (CA-1) einen Scheitelpunkt (E2) hat, an dem sich die geraden Linien treffen, und
der Scheitelpunkt (E2) des zweiten Abschnitts (CA) relativ weiter vom Mittelpunkt (C-OP1) der ersten Öffnung (OP1) entfernt ist als der erste Abschnitt (OA-1).

5. Anzeigefeld nach einem der Ansprüche 1 bis 4, wobei
(i) der erste Abschnitt (OA) eine Vielzahl von ersten Abschnitten (OA) beinhaltet,
der zweite Abschnitt (CA) eine Vielzahl von zweiten Abschnitten (CA) beinhaltet und
die Vielzahl von ersten Abschnitten (OA) abwechselnd mit der Vielzahl von zweiten Abschnitten (CA) angeordnet ist; und/oder
(ii) die erste Öffnung (OP1) bei Betrachtung in einer Ebene eine kreisförmige Form aufweist.

6. Anzeigefeld (DP) nach einem der Ansprüche 1 bis 5, wobei
die Leuchtdiode (LD) umfasst:
eine erste Elektrode (EL1);
eine zweite Elektrode (EL2), die auf der ersten Elektrode (EL1) angeordnet ist; und
eine Leuchtschicht (EML), die zwischen der ersten und zweiten Elektrode (EL1, EL2) angeordnet ist, und
die zweite Elektrode (EL2) elektrisch mit der inneren Seitenfläche (IS_L2) der zweiten Schicht (L2) im ersten Abschnitt (OA) verbunden ist, wobei das Anzeigefeld (DP) ferner Folgendes umfasst:
eine Pixeldefinitionsschicht (PDL), die auf der Isolierschicht (60) angeordnet ist und Folgendes beinhaltet:
eine dritte Öffnung (OP-PDL), die einen Abschnitt der ersten Elektrode (EL1) freilegt; und
eine vierte Öffnung (OP-CN), die die erste Öffnung (OP1) überlappt; und
einen Separator (SPR), der auf der Pixeldefinitionsschicht (PDL) angeordnet ist.

7. Anzeigefeld (DP) nach einem der Ansprüche 1 bis 6, weiter umfassend:
eine Kappenstruktur (CPP), das die durch die erste Öffnung (OP1) freiliegende Verbindungsleitung (CN) abdeckt,
wobei die Kappenstruktur (CPP) den ersten Abschnitt (OA) berührt und vom zweiten Abschnitt (CA) beabstandet ist.

8. Anzeigefeld (DP), umfassend:
einen Transistor:
eine Leuchtdiode (LD), die auf dem Transistor angeordnet ist;
eine Isolierschicht (60), die auf dem Transistor angeordnet ist und eine erste Öffnung (OP1') beinhaltet; und
eine Verbindungsleitung (CN-A, CN-B, CN-C), die zumindest teilweise von der Isolierschicht (60) bedeckt ist und die lichtemittierende Vorrichtung (LD) und den Transistor elektrisch verbindet, wobei die Verbindungsleitung (CN-A, CN-B, CN-C) Folgendes umfasst:
ein erstes Verbindungsteil (ECP-A, ECP-B, ECP-C), das einen ersten Abschnitt (P1), der sich in einer Richtung erstreckt, und einen zweiten Abschnitt (P2), der sich vom ersten Abschnitt (P1) zu einer ersten Querrichtung erstreckt, die die Richtung schneidet, und elektrisch mit der lichtemittierenden Vorrichtung (LD) verbunden ist, umfasst;
ein zweites Verbindungsteil (DCP), das elektrisch mit dem Transistor verbunden ist; und
ein Verbindungsteil (CNP), das sich vom ersten Verbindungsteil (ECP-A, ECP-B, ECP-C) zum zweiten Verbindungsteil (DCP) erstreckt,
wobei zumindest eine von einer ersten Seitenfläche (IS1) des ersten Abschnitts (P1), die sich in der Richtung erstreckt, und einer zweiten Seitenfläche (IS2) des zweiten Abschnitts (P2), die sich in der ersten Querrichtung erstreckt, die erste Öffnung (OP1') überlappt;
**dadurch gekennzeichnet, dass**
die Verbindungsleitung (N-A, CN-B, CN-C, CN-D) eine erste Schicht (L1) und eine zweite Schicht (L2), die unter der ersten Schicht (L1) angeordnet ist, umfasst und
eine Seitenfläche (IS_L1) der ersten Schicht (L1) weiter als eine Seitenfläche (IS_L2) der zweiten Schicht (L2) in einem Abschnitt (OA) der ersten und zweiten Seitenflächen (IS_L1, IS_L2), der die erste Öffnung überlappt, vorragt, um ein Spitzenteil (TP) bereitzustellen.

9. Anzeigefeld (DP) nach Anspruch 8, wobei ein Winkel zwischen der ersten Seitenfläche (IS1) und der zweiten Seitenfläche (IS2) kleiner als etwa 180 Grad ist.

10. Anzeigefeld (DP) nach Anspruch 8 oder Anspruch 9, wobei
die Verbindungsleitung (CN-B) ferner einen dritten Abschnitt (P3) umfasst, der sich vom zweiten Abschnitt (P2) zu einer zweiten Querrichtung erstreckt, die die erste Querrichtung schneidet und dem ersten Abschnitt (P1) in der ersten Querrichtung zugewandt ist, und
zumindest ein Abschnitt der ersten Seitenfläche (IS1), die zweite Seitenfläche (IS2) und zumindest ein Abschnitt einer dritten Seitenfläche (IS3) des dritten Abschnitts (P3), der sich in der zweiten Querrichtung erstreckt, die erste Öffnung (OP1') überlappen.

11. Anzeigefeld (DP) nach Anspruch 8 oder Anspruch 9, wobei
die Verbindungsleitung (CN-C) ferner einen dritten Abschnitt (P3) umfasst, der sich vom zweiten Abschnitt (P2) zu einer zweiten Querrichtung erstreckt, die die erste Querrichtung schneidet und dem ersten Abschnitt (P1) in der ersten Querrichtung zugewandt ist,
zumindest ein Abschnitt der ersten Seitenfläche (IS1) und zumindest ein Abschnitt einer dritten Seitenfläche (IS3) des dritten Abschnitts (P3), der sich in der zweiten Querrichtung erstreckt, die erste Öffnung (OP1') überlappen und
die zweite Seitenfläche (IS2) die erste Öffnung nicht überlappt.

12. Anzeigefeld (DP) nach Anspruch 8 oder Anspruch 9, wobei
die erste Seitenfläche (IS1), die die erste Öffnung (OP1') überlappt, konkave Abschnitte (A1-A3) und konvexe Abschnitte (B1-B3), die abwechselnd mit den konkaven Abschnitten (A1-A3) angeordnet sind, umfasst,
jeder der konkaven Abschnitte (A1-A3) eine Krümmung aufweist, die es ermöglicht, einen Krümmungsmittelpunkt außerhalb des ersten Abschnitts (P1) zu definieren, und
jeder der konvexen Abschnitte (B1-B3) eine Krümmung aufweist, die es ermöglicht, einen Krümmungsmittelpunkt innerhalb des ersten Abschnitts (P1) zu definieren, wobei optional:
die erste Seitenfläche (IS1) ferner einen Dummy-Abschnitt (D1-D4) umfasst, der von der Isolierschicht (60) bedeckt ist, und
der Dummy-Abschnitt (D1-D3) eine Form aufweist, die einer Form eines Abschnitts der konkaven Abschnitte (A1-A3) oder der konvexen Abschnitte (B1-B3) entspricht.

13. Anzeigefeld (DP) nach Anspruch 8 oder Anspruch 9, wobei
die erste Seitenfläche (IS), die die erste Öffnung (OP1') überlappt, konkave Abschnitte (A1-A3) und konvexe Abschnitte (B1-B3), die abwechselnd mit den konkaven Abschnitten (A1-A3) angeordnet sind, umfasst,
jeder der konkaven Abschnitte (A1-A3) und jeder der konvexen Abschnitte (B1-B3) bei Betrachtung in einer Ebene durch gerade Linien definiert sind und
ein Mittelpunkt jedes der konkaven Abschnitte (A1-A3) und ein Mittelpunkt jedes der konvexen Abschnitte (B1-B3) jeweils in entgegengesetzten Richtungen voneinander beabstandet sind, bezogen auf eine gedachte Linie (L), die sich in der Richtung erstreckt.

14. Anzeigefeld (DP) nach einem der Ansprüche 8 bis 13, wobei die lichtemittierende Vorrichtung (LD) Folgendes umfasst:
eine erste Elektrode (EL1);
eine zweite Elektrode (EL2), die auf der ersten Elektrode (EL1) angeordnet ist; und
eine Leuchtschicht (EML), die zwischen der ersten und zweiten Elektrode (EL1, EL2) angeordnet ist, und
die zweite Elektrode (EL2) elektrisch mit der Seitenfläche (IS_L2) der zweiten Schicht (L2) in dem Abschnitt der ersten und zweiten Seitenfläche (IS_L1, IS_L2) verbunden ist, der die erste Öffnung (OP1') überlappt, wobei das Anzeigefeld (DP) mehr optional ferner Folgendes umfasst:
eine Pixeldefinitionsschicht (PDL), die auf der Isolierschicht (60) angeordnet ist und Folgendes beinhaltet:
eine lichtemittierende Öffnung (OP-PDL), die einen Abschnitt der ersten Elektrode (EL1) freilegt; und
eine zweite Öffnung (OP2'), die die erste Öffnung (OP1') überlappt; und
einen Separator (SPR), der auf der Pixeldefinitionsschicht (PDL) angeordnet ist.

## Revendications

1. Panneau d'affichage (DP) comprenant :
un transistor :
un dispositif électroluminescent (LD) disposé sur le transistor ;
une couche isolante (60) disposée sur le transistor et incluant une première ouverture (OP1) ; et
un câblage de connexion (CN) au moins partiellement recouvert par la couche isolante (60) et connectant électriquement le dispositif électroluminescent (LD) et le transistor, le câblage de connexion (CN) comprenant :
une première partie de connexion (ECP) connectée électriquement au dispositif électroluminescent (LD) et incluant une deuxième ouverture (OP-CN) ;
une seconde partie de connexion (DCP) connectée électriquement au transistor ; et
une partie de connexion (CNP) s'étendant de la première partie de connexion (ECP) à la seconde partie de connexion (DCP),
dans lequel une surface latérale intérieure (IS) du câblage de connexion (CN), qui définit la deuxième ouverture (OP-CN), comprend :
une première portion (OA) chevauchant la première ouverture (OP1) ; et
une deuxième portion (CA) recouverte par la couche isolante (60) :
**caractérisé en ce que**
le câblage de connexion (CN) comprend une première couche (L1) et une seconde couche (L2) disposée sous la première couche (L1),
une surface latérale intérieure (IS_L1) de la première couche (L1) fait saillie davantage qu'une surface latérale intérieure (IS_L2) de la seconde couche (L2) dans la première portion (OA) pour fournir une partie de pointe (TP), et
la surface latérale intérieure (IS_L1) de la première couche (L1) est alignée avec la surface latérale intérieure (IS_L2) de la seconde couche (L2) dans la deuxième portion (CA).

2. Panneau d'affichage (DP) selon la revendication 1, dans lequel la première portion (OA) est disposée plus proche d'un centre (C-OP1) de la première ouverture (OP1) que la seconde partie (CA) lorsqu'elle est vue dans un plan.

3. Panneau d'affichage (DP) selon la revendication 1 ou la revendication 2, dans lequel
chacune de la première portion (OA) et de la deuxième portion (CA) présente une forme de ligne courbe lorsqu'elle est vue dans un plan,
un centre de courbure (CC1) de la première portion (OA) est défini à l'intérieur de la première partie de connexion (ECP), et
un centre de courbure (CC2) de la deuxième portion (CA) est défini à l'extérieur de la première partie de connexion (ECP).

4. Panneau d'affichage (DP) selon la revendication 1 ou la revendication 2, dans lequel
chacune de la première portion (OA-1) et de la deuxième portion (CA-1) présente une forme définie par des lignes droites lorsqu'elle est vue dans un plan,
la première portion (OA-1) présente un sommet (E1) où les lignes droites se rencontrent mutuellement,
le sommet (E1) de la première portion (OA) est relativement plus proche d'un centre (C-OP1) de la première ouverture (OA-1) que ne l'est la deuxième portion (CA-1),
la deuxième portion (CA-1) présentent un sommet (E2) où les lignes droites se rencontrent mutuellement, et
le sommet (E2) de la deuxième portion (CA) est relativement plus éloigné du centre (C-OP1) de la première ouverture (OP1) que ne l'est la première portion (OA-1).

5. Panneau d'affichage selon l'une quelconque des revendications 1 à 4, dans lequel :
(i) la première portion (OA) inclut une pluralité de premières portions (OA),
la deuxième portion (CA) inclut une pluralité de secondes portions (CA), et
la pluralité des premières portions (OA) sont agencées en alternance avec la pluralité de secondes portions (CA) ; et/ou
(ii) la première ouverture (OP1) présente une forme circulaire lorsqu'elle est vue dans un plan.

6. Panneau d'affichage (DP) selon l'une quelconque des revendications 1 à 5, dans lequel
le dispositif électroluminescent (LD) comprend :
une première électrode (EL1) ;
une seconde électrode (EL2) disposée sur la première électrode (EL1) ; et
une couche électroluminescente (EML) disposée entre les première et seconde électrodes (EL1, EL2), et
la seconde électrode (EL2) est connectée électriquement à la surface latérale intérieure (IS_L2) de la seconde couche (L2) dans la première portion (OA), facultativement dans lequel : le panneau d'affichage (DP) comprend en outre :
une couche de définition de pixels (PDL) disposée sur la couche isolante (60) et incluant :
une troisième ouverture (OP-PDL) exposant une portion de la première électrode (EL1) ; et
une quatrième ouverture (OP-CN) chevauchant la première ouverture (OP1) ; et
un séparateur (SPR) disposé sur la couche de définition de pixels (PDL).

7. Panneau d'affichage (DP) selon l'une quelconque des revendications 1 à 6, comprenant en outre :
un motif de coiffage (CPP) recouvrant le câblage de connexion (CN) exposé à travers la première ouverture (OP1),
dans lequel le motif de coiffage (CPP) vient en contact avec la première portion (OA) et est espacé de la deuxième portion (CA).

8. Panneau d'affichage (DP) comprenant :
un transistor :
un dispositif électroluminescent (LD) disposé sur le transistor ;
une couche isolante (60) disposée sur le transistor et incluant une première ouverture (OP1) ; et
un câblage de connexion (CN-A, CN-B, CN-C) au moins partiellement recouvert par la couche isolante (60) et connectant électriquement le dispositif électroluminescent (LD) et le transistor, le câblage de connexion (CN-A, CN-B, CN-C) comprenant :
une première partie de connexion (ECP-A, ECP-B, ECP-C) comprenant une première portion (P1) s'étendant dans une direction et une deuxième portion (P2) s'étendant de la première portion (P1) vers une première direction transversale recoupant la direction et connectée électriquement au dispositif électroluminescent (LD) ;
une seconde partie de connexion (DCP) connectée électriquement au transistor ; et
une partie de connexion (CNP) s'étendant de la première partie de connexion (ECP-A, ECP-B, ECP-C) à la seconde partie de connexion (DCP),
dans lequel au moins une d'une première surface latérale (IS1) de la première portion (P1) s'étendant dans la direction et d'une première surface latérale (IS2) de la seconde portion(P2) s'étendant dans la première direction transversale chevauche la première ouverture (OP1') ;
**caractérisé en ce que**
le câblage de connexion (CN-A, CN-B, CN-C, CN-D) comprend une première couche (L1) et une seconde couche (L2) disposée sous la première couche (L1), et
une surface latérale (IS_L1) de la première couche (L1) fait saillie davantage qu'une surface latérale (IS_L2) de la seconde couche (L2) dans une portion des première et seconde surfaces latérales (IS_L1, IS_L2), qui chevauche la première ouverture pour fournir une partie de pointe (TP).

9. Panneau d'affichage (DP) selon la revendication 8, dans lequel un angle entre la première surface latérale (IS1) et la première surface latérale (IS2) est inférieur à environ 180 degrés.

10. Panneau d'affichage (DP) selon la revendication 8 ou la revendication 9, dans lequel :
le câblage de connexion (CN-B) comprend en outre une troisième portion (P3) s'étendant de la deuxième portion (P2) vers une seconde direction transversale recoupant la première direction transversale et faisant face à la première portion (P1) dans la première direction transversale, et
au moins une portion de la première surface latérale (IS1), la deuxième surface latérale (IS2) et au moins une portion d'une troisième surface latérale (IS3) de la troisième portion (P3) s'étendant dans la seconde direction transversale chevauchent la première ouverture (OP1').

11. Panneau d'affichage (DP) selon la revendication 8 ou la revendication 9, dans lequel :
le câblage de connexion (CN-C) comprend en outre une troisième portion (P3) s'étendant de la deuxième portion (P2) vers une seconde direction transversale recoupant la première direction transversale et faisant face à la première portion (P1) dans la première direction transversale,
au moins une portion de la première surface latérale (IS1) et au moins une portion d'une troisième surface latérale (IS3) de la troisième portion (P3) s'étendant dans la seconde direction transversale chevauchent la première ouverture (OP1'), et
la deuxième surface latérale (IS2) ne chevauche pas la première ouverture.

12. Panneau d'affichage (DP) selon la revendication 8 ou la revendication 9, dans lequel :
la première surface latérale (IS1) chevauchant la première ouverture (OP1') comprend des portions concaves (A1-A3) et des portions convexes (B1-B3) agencées alternativement avec les parties concaves (A1-A3),
chacune des portions concaves (A1-A3) présente une courbure permettant de définir un centre de courbure à l'extérieur de la première portion (P1), et
chacune des portions convexes (B1-B3) présente une courbure permettant de définir un centre de courbure à l'intérieur de la première portion (P1), facultativement dans lequel :
la première surface latérale (IS1) comprend en outre une portion factice (D1-D4) recouverte par la couche isolante (60), et
la portion factice (D1-D3) présente une forme correspondant à une forme d'une portion des portions concaves (A1-A3) ou des portions convexes (B1-B3).

13. Panneau d'affichage (DP) selon la revendication 8 ou la revendication 9, dans lequel :
la première surface latérale (IS) chevauchant la première ouverture (OP1') comprend des portions concaves (A1-A3) et des portions convexes (B1-B3) agencées alternativement avec les parties concaves (A1-A3),
chacune des portions concaves (A1-A3) et chacune des portions convexes (B1-B3) sont définies par des lignes droites lorsqu'elles sont vues dans un plan, et
un centre de chacune des portions concaves (A1-A3) et un centre de chacune des portions convexes (B1-B3) sont espacés l'un de l'autre dans des directions opposées l'une à l'autre par rapport à une ligne imaginaire (L) s'étendant dans la direction.

14. Panneau d'affichage (DP) selon l'une quelconque des revendications 8 à 13, dans lequel le dispositif électroluminescent (LD) comprend :
une première électrode (EL1) ;
une seconde électrode (EL2) disposée sur la première électrode (EL1) ; et
une couche électroluminescente (EML) disposée entre les première et seconde électrodes (EL1, EL2), et
la seconde électrode (EL2) est connectée électriquement à la surface latérale (IS_L2) de la seconde couche (L2) dans la portion des première et deuxième surfaces latérales (IS_L1, IS_L2), qui chevauche la première ouverture (OP1'), plus facultativement dans lequel le panneau d'affichage (DP) comprend en outre :
une couche de définition de pixels (PDL) disposée sur la couche isolante (60) et incluant :
une ouverture électroluminescente (OP-PDL) exposant une partie de la première électrode (EL1) ; et
une deuxième ouverture (OP2') chevauchant la première ouverture (OP1') ; et
un séparateur (SPR) disposé sur la couche de définition de pixels (PDL).
